# EUROPEAN PATENT APPLICATION

(11) **EP 4 576 971 A1**
(43) Date of publication of application: **25.06.2025**
(21) Application number: 23869814.6
(22) Date of filing: 28.06.2023
(51) Int. Cl.: H10B 10/00

(54) **MEMORY AND ELECTRONIC DEVICE**

(30) Priority: 28.09.2022 CN 202211192290
(71) Applicant: Huawei Technologies Co., Ltd., Shenzhen, Guangdong 518129 (CN)
(72) Inventor: LI, Junkang, Shenzhen, Guangdong 518129 (CN); ZHAN, Shijie, Shenzhen, Guangdong 518129 (CN); WU, Ying, Shenzhen, Guangdong 518129 (CN); XU, Jeffrey Junhao, Shenzhen, Guangdong 518129 (CN)
(74) Representative: Goddar, Heinz J.
(86) International application number: PCT/CN2023/103507
(87) International publication number: WO 2024/066566

(57) **Abstract**

Embodiments of this application relate to the field of memory technologies, and provide a memory and an electronic device, to implement a unipolar memory, and improve area utilization of the memory. The memory includes a first circuit structure layer, a second circuit structure layer, and a plurality of interconnection structures. The first circuit structure layer includes a first inverter. The second circuit structure layer includes a second inverter. A plurality of transistors of the first inverter and a plurality of transistors of the second inverter have a same polarity. The plurality of transistors of the first inverter and the plurality of transistors of the second inverter are sequentially arranged in a first direction parallel to a reference plane. Orthographic projections of the plurality of transistors of the first inverter on the reference plane overlap orthographic projections of the plurality of transistors of the second inverter on the reference plane. The first inverter is electrically connected to the second inverter through the plurality of interconnection structures. The memory is used in an electronic device, to improve a storage capability of the electronic device.

## Description

This application claims priority to Chinese Patent Application No. 202211192290.5, filed with the China National Intellectual Property Administration on September 28, 2022 and entitled "MEMORY AND ELECTRONIC DEVICE", which is incorporated herein by reference in its entirety.

### TECHNICAL FIELD

This application relates to the field of memory technologies, and in particular, to a memory and an electronic device.

### BACKGROUND

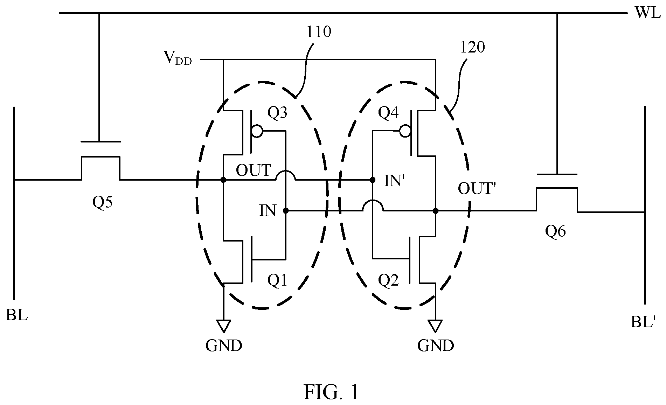

A static random access memory (static random access memory, SRAM) is a semiconductor memory based on a flip-flop logic circuit. As long as the SRAM is powered on, information written into the SRAM does not disappear, and the circuit does not need to be refreshed. As shown in FIG. 1, a conventional silicon (Si)-based SRAM includes six metal-oxide-semiconductor field-effect transistors (metal-oxide-semiconductor field-effect transistors, MOSFETs), where Q1, Q2, Q5, and Q6 are n-type metal-oxide-semiconductor field-effect transistors (n-type metal oxide semiconductor field effect transistors, NMOSFETs), and Q3 and Q4 are p-type metal-oxide-semiconductor field-effect transistors (p-type metal oxide semiconductor field effect transistors, PMOSFETs).

In a computer storage architecture, the SRAM has a high storage speed, is mainly used for caching, and is generally integrated into a central processing unit (central processing unit, CPU). With continuous improvement of computer performance, as an important medium for data exchange, the SRAM occupies an increasingly large area in the CPU, resulting in serious deterioration in power, performance, area, and cost (power, performance, area, and cost, PPAC).

Therefore, use of a 3D (three-dimensional) stacking manner is proposed in both the academia and the industry, to continuously improve a process of a chip, and improve area utilization of the chip. Relative to another logic computing unit, the SRAM is an independent module. It is easier to perform 3D integration on the SRAM and a logic device through a back-end-of-line (back-end-of-line, BEOL) process or a stacking process.

However, for the conventional silicon-based SRAM, it is quite difficult to implement 3D integration through the BEOL process or the stacking process, and a quite high requirement is imposed on a process temperature. An oxide semiconductor has advantages of stackability and a low temperature process. However, the oxide semiconductor is of a unipolar channel material, and when being used in the SRAM, makes a circuit design of the SRAM more complex. Consequently, an area occupied by a component (for example, a transistor) in the SRAM and an area occupied by a connection line between components accordingly increase.

### SUMMARY

Embodiments of this application provide a memory and an electronic device, to implement a unipolar memory, and improve area utilization of the memory.

The following technical solutions are used in embodiments of this application, to achieve the foregoing objectives.

According to a first aspect, a memory is provided. The memory includes a first circuit structure layer, a second circuit structure layer, and a plurality of interconnection structures. The first circuit structure layer includes a first inverter. The second circuit structure layer is stacked with the first circuit structure layer, and includes a second inverter. The plurality of interconnection structures are located between the first circuit structure layer and the second circuit structure layer.

The first inverter and the second inverter each include a plurality of transistors. The plurality of transistors of the first inverter and the plurality of transistors of the second inverter have a same polarity. The plurality of transistors of the first inverter and the plurality of transistors of the second inverter are all sequentially arranged in a first direction parallel to a reference plane. The reference plane is a plane on which the lower surface of the first circuit structure layer is located. Orthographic projections of the plurality of transistors of the first inverter on the reference plane overlap orthographic projections of the plurality of transistors of the second inverter on the reference plane. The first inverter is electrically connected to the second inverter through the plurality of interconnection structures.

In the memory provided in this embodiment of this application, a plurality of transistors of the first inverter and the second inverter have a same polarity. Therefore, in a process of preparing the memory, the plurality of transistors can be prepared from a unipolar channel material (for example, an oxide semiconductor material or an organic semiconductor material). In this way, the memory can be prepared using a back-end-of-line process or a stacking process. This simplifies a process, implements 3D integration of the memory with a logic device that controls the memory, reduces an area occupied by the memory, and improves area utilization of the memory.

The plurality of transistors have the same polarity, so that the plurality of transistors can be further compactly arranged, and extra space does not need to be used in a memory cell to separate transistors of different polarities. This can further reduce an area occupied by the memory cell, thereby improving the area utilization of the memory.

Compared with a case in which the entire memory cell is disposed in a same circuit structure layer, in this embodiment of this application, the first inverter of the memory cell is disposed in the first circuit structure layer, and the second inverter is disposed in the second circuit structure layer. This implements 3D stacking of the memory cell, thereby further improving the area utilization of the memory.

In addition, in the memory provided in this embodiment of this application, the plurality of transistors of the first inverter are sequentially arranged in the first direction. The plurality of transistors are regularly arranged, so that an area occupied by the first inverter in the first circuit structure layer can be small. The plurality of transistors of the second inverter are sequentially arranged in the first direction. The plurality of transistors are regularly arranged, so that an area occupied by the second inverter in the second circuit structure layer can be small. The areas occupied by the first inverter and the second inverter are small, so that an area of an orthographic projection of the memory cell on the reference plane is small.

The orthographic projections of the plurality of transistors of the first inverter on the reference plane overlap the orthographic projections of the plurality of transistors of the second inverter on the reference plane. In this way, on one hand, it is conductive to implementation of electrically connecting the first inverter to the second inverter through the plurality of interconnection structures, to simplify a connection form between the first inverter and the second inverter. On the other hand, an area occupied by each memory cell can be further reduced, to improve the area utilization of the memory.

In some embodiments, the transistor includes a first electrode, a gate, and a second electrode that are sequentially arranged in a second direction. The second direction is parallel to the reference plane and perpendicular to the first direction In an orthographic projection toward the reference plane, the gate of the transistor of the first inverter overlaps the first electrode of the transistor of the second inverter, and the second electrode of the transistor of the first inverter overlaps the gate of the transistor of the second inverter.

In this way, an overlapping area between the transistor of the first inverter and the transistor of the second inverter is large, and the area occupied by the memory cell is small. In addition, the gate of the transistor of the first inverter overlaps the first electrode of the transistor of the second inverter, and the second electrode of the transistor of the first inverter overlaps the gate of the transistor of the second inverter. This further helps make the interconnection structure perpendicular to the first circuit structure layer and the second circuit structure layer, and simplifies the plurality of interconnection structures, so that an orthographic projection of the interconnection structure on the reference plane is small, and an area occupied by the interconnection structure is small.

In some embodiments, in the orthographic projection toward the reference plane, the first electrode of the transistor of the first inverter is staggered with the second electrode of the transistor of the second inverter. Through such a disposal, it can be convenient to electrically connect the plurality of transistors of the first inverter and the second inverter to other lines (for example, a supply voltage line and a ground line).

In some embodiments, the first inverter includes a first transistor, a second transistor, a third transistor, and a fourth transistor. In the first direction, the third transistor, the first transistor, the fourth transistor, and the second transistor are sequentially arranged. The first transistor and the fourth transistor share a gate. The first circuit structure layer further includes a first connection line and a second connection line. A second electrode of the third transistor is electrically connected to a second electrode of the first transistor through the first connection line. A second electrode of the fourth transistor is electrically connected to a second electrode of the second transistor through the second connection line.

In some embodiments, the second inverter includes a fifth transistor, a sixth transistor, a seventh transistor, and an eighth transistor. In the first direction, the fifth transistor, the seventh transistor, the sixth transistor, and the eighth transistor are sequentially arranged. The sixth transistor and the seventh transistor share a gate. The second circuit structure layer further includes a third connection line and a fourth connection line. A first electrode of the fifth transistor is electrically connected to a first electrode of the seventh transistor through the third connection line. A first electrode of the sixth transistor is electrically connected to a first electrode of the eighth transistor through the fourth connection line.

In some embodiments, the plurality of interconnection structures include a first interconnection structure, a second interconnection structure, a third interconnection structure, and a fourth interconnection structure. A gate of the third transistor is electrically connected to the first electrode of the seventh transistor through the first interconnection structure. The gate of the seventh transistor is electrically connected to the first connection line through the second interconnection structure. The gate of the first transistor is electrically connected to the fourth connection line through the third interconnection structure. A gate of the eighth transistor is electrically connected to the second connection line through the fourth interconnection structure.

In some embodiments, the first circuit structure layer further includes a first gating transistor. In the first direction, the first gating transistor is located on a side that is of the third transistor and that is away from the first transistor. The second circuit structure layer further includes a second gating transistor. In the first direction, the second gating transistor is located on a side that is of the eighth transistor and that is away from the sixth transistor. The first gating transistor and the second gating transistor include first electrodes, gates, and second electrodes that are sequentially arranged in the second direction. The second electrode of the first gating transistor is electrically connected to the first connection line.

In some embodiments, the plurality of interconnection structures include a fifth interconnection structure. The first electrode of the second gating transistor is electrically connected to a gate of the second transistor through the fifth interconnection structure.

In some embodiments, the memory further includes a fifth connection line and a sixth connection line. The fifth connection line and the sixth connection line are located on a side that is of the second circuit structure layer and that is away from the first circuit structure layer. The fifth connection line is electrically connected to a gate of the fifth transistor and the gate of the eighth transistor. The sixth connection line is electrically connected to the third connection line and the first electrode of the second gating transistor. In the orthographic projection toward the reference plane, the fifth connection line overlaps the gate of the fifth transistor and the gate of the eighth transistor, and the sixth connection line overlaps the first electrode of the seventh transistor and the first electrode of the second gating transistor.

In some embodiments, the gate of the first gating transistor includes a first part and a second part. The second part is away from the third transistor relative to the first part. In the orthographic projection toward the reference plane, the first part overlaps the first electrode of the fifth transistor, and the second part does not overlap the first electrode of the fifth transistor. The memory further includes a word line, located on the side that is of the second circuit structure layer and that is away from the first circuit structure layer. The word line extends in the first direction, and the word line is electrically connected to the gate of the first gating transistor and the gate of the second gating transistor. In the orthographic projection toward the reference plane, the word line overlaps the second part and the gate of the second gating transistor.

In some embodiments, the memory further includes a first bit line and a second bit line, located on the side that is of the second circuit structure layer and that is away from the first circuit structure layer, and extending in the second direction. The first bit line is electrically connected to the first electrode of the first gating transistor. The second bit line is electrically connected to the second electrode of the second gating transistor. In the orthographic projection toward the reference plane, the first bit line overlaps the first electrode of the first gating transistor, and the second bit line overlaps the second electrode of the second gating transistor.

In some embodiments, the memory further includes a first bit line, a plurality of first supply voltage lines, a plurality of first ground lines, a second bit line, a plurality of second supply voltage lines, and a plurality of second ground lines. The first bit line, the plurality of first supply voltage lines, and the plurality of first ground lines are located on a side that is of the first circuit structure layer and that is away from the second circuit structure layer, and all extend in the second direction. The second bit line, the plurality of second supply voltage lines, and the plurality of second ground lines are located on the side that is of the second circuit structure layer and that is away from the first circuit structure layer, and all extend in the second direction.

The first bit line is electrically connected to the first electrode of the first gating transistor. The plurality of first supply voltage lines are electrically connected to a first electrode of the first transistor and a first electrode of the second transistor. The plurality of first ground lines are electrically connected to a first electrode of the third transistor and a first electrode of the fourth transistor. In the orthographic projection toward the reference plane, the first bit line overlaps the first electrode of the first gating transistor, the plurality of first supply voltage lines overlap the first electrode of the first transistor and the first electrode of the second transistor, and the plurality of first ground lines overlap the first electrode of the third transistor and the first electrode of the fourth transistor.

The second bit line is electrically connected to the second electrode of the second gating transistor. The plurality of second supply voltage lines are electrically connected to a second electrode of the fifth transistor and a second electrode of the sixth transistor. The plurality of second ground lines are electrically connected to a second electrode of the seventh transistor and a second electrode of the eighth transistor. In the orthographic projection toward the reference plane, the second bit line overlaps the second electrode of the second gating transistor, the plurality of second supply voltage lines overlap the second electrode of the fifth transistor and the second electrode of the sixth transistor, and the plurality of second ground lines overlap the second electrode of the seventh transistor and the second electrode of the eighth transistor.

In some embodiments, the second inverter includes a fifth transistor, a sixth transistor, a seventh transistor, and an eighth transistor. In the first direction, the seventh transistor, the sixth transistor, the eighth transistor, and the fifth transistor are sequentially arranged. The fifth transistor and the eighth transistor share a gate. The sixth transistor and the seventh transistor share a gate. The second circuit structure layer further includes a seventh connection line. A first electrode of the sixth transistor is electrically connected to a first electrode of the eighth transistor through the seventh connection line.

In some embodiments, the plurality of interconnection structures include a first interconnection structure, a second interconnection structure, a third interconnection structure, a fourth interconnection structure, and a fifth interconnection structure. A gate of the third transistor is electrically connected to a first electrode of the seventh transistor through the first interconnection structure. The gate of the seventh transistor is electrically connected to the first connection line through the second interconnection structure. The gate of the first transistor is electrically connected to the seventh connection line through the third interconnection structure. The second connection line is electrically connected to the gate of the eighth transistor through the fourth interconnection structure. A gate of the second transistor is electrically connected to a first electrode of the fifth transistor through the fifth interconnection structure.

In some embodiments, the first circuit structure layer further includes a first gating transistor and a second gating transistor. In the first direction, the first gating transistor is located on a side that is of the third transistor and that is away from the first transistor, and the second gating transistor is located on a side that is of the second transistor and that is away from the fourth transistor. The second circuit structure layer further includes a third gating transistor and a fourth gating transistor. In the first direction, the third gating transistor is located on a side that is of the seventh transistor and that is away from the sixth transistor, and the fourth gating transistor is located on a side that is of the fifth transistor and that is away from the eighth transistor.

The first gating transistor, the second gating transistor, the third gating transistor, and the fourth gating transistor include first electrodes, gates, and second electrodes that are sequentially arranged in the second direction. The second electrode of the first gating transistor is electrically connected to the first connection line. The second electrode of the second gating transistor is electrically connected to the second connection line. The second circuit structure layer further includes an eighth connection line. The first electrode of the fifth transistor is electrically connected to the first electrode of the fourth gating transistor through the eighth connection line.

In some embodiments, the memory further includes a ninth connection line and a tenth connection line. The ninth connection line and the tenth connection line are located on a side that is of the second circuit structure layer and that is away from the first circuit structure layer. The ninth connection line is electrically connected to the first electrode of the third gating transistor and the seventh connection line. The tenth connection line is electrically connected to the first electrode of the seventh transistor and the eighth connection line.

In some embodiments, the memory further includes two first connection parts and two second connection parts. One end of the ninth connection line is electrically connected to the first electrode of the third gating transistor through one of the first connection parts, and the other end of the ninth connection line is electrically connected to the seventh connection line through the other of the first connection parts. One end of the tenth connection line is electrically connected to the first electrode of the seventh transistor through one of the second connection parts, and the other end of the tenth connection line is electrically connected to the eighth connection line through the other of the second connection parts.

The two first connection parts and the two second connection parts are alternately arranged in the first direction. The ninth connection line and the tenth connection line are at a same layer, the ninth connection line avoids the second connection part, and the tenth connection line avoids the first connection part. Alternatively, the ninth connection line is located on a side that is of the tenth connection line and that is away from the second circuit structure layer, and the tenth connection line is in a broken line shape. In the orthographic projection toward the reference plane, the tenth connection line avoids the first connection part.

In some embodiments, the gate of the first gating transistor includes a first part and a second part. The second part is away from the third transistor relative to the first part. In the orthographic projection toward the reference plane, the first part overlaps the first electrode of the third gating transistor, and the second part does not overlap the first electrode of the third gating transistor. The gate of the second gating transistor includes a third part and a fourth part. The fourth part is away from the second transistor relative to the third part. In the orthographic projection toward the reference plane, the third part overlaps the first electrode of the fourth gating transistor, and the fourth part does not overlap the first electrode of the fourth gating transistor.

The memory further includes a word line. The word line is located on the side that is of the second circuit structure layer and that is away from the first circuit structure layer, and extends in the first direction. The word line is electrically connected to the gate of the first gating transistor, the gate of the second gating transistor, the gate of the third gating transistor, and the gate of the fourth gating transistor. In the orthographic projection toward the reference plane, the word line overlaps the second part, the fourth part, the gate of the third gating transistor, and the gate of the fourth gating transistor.

In some embodiments, the memory further includes a first bit line and a second bit line. The first bit line and the second bit line are located on the side that is of the second circuit structure layer and that is away from the first circuit structure layer, and extend in the second direction. The first bit line is electrically connected to the first electrode of the first gating transistor and the second electrode of the third gating transistor. The second bit line is electrically connected to the first electrode of the second gating transistor and the second electrode of the fourth gating transistor. In the orthographic projection toward the reference plane, the first bit line overlaps the first electrode of the first gating transistor and the second electrode of the third gating transistor, and the second bit line overlaps the first electrode of the second gating transistor and the second electrode of the fourth gating transistor.

In some embodiments, the memory further includes a first bit line, a second bit line, a plurality of first supply voltage lines, a plurality of first ground lines, a third bit line, a fourth bit line, a plurality of second supply voltage lines, and a plurality of second ground lines.

The first bit line, the second bit line, the plurality of first supply voltage lines, and the plurality of first ground lines are located on a side that is of the first circuit structure layer and that is away from the second circuit structure layer, and all extend the second direction. The third bit line, the fourth bit line, the plurality of second supply voltage lines, and the plurality of second ground lines are located on the side that is of the second circuit structure layer and that is away from the first circuit structure layer, and all extend in the second direction.

The first bit line is electrically connected to the first electrode of the first gating transistor. The second bit line is electrically connected to the first electrode of the second gating transistor. The plurality of first supply voltage lines are electrically connected to a first electrode of the first transistor and a first electrode of the second transistor. The plurality of first ground lines are electrically connected to a first electrode of the third transistor and a first electrode of the fourth transistor. In the orthographic projection toward the reference plane, the first bit line overlaps the first electrode of the first gating transistor, the second bit line overlaps the first electrode of the second gating transistor, the plurality of first supply voltage lines overlap the first electrode of the first transistor and the first electrode of the second transistor, and the plurality of first ground lines overlap the first electrode of the third transistor and the first electrode of the fourth transistor.

The third bit line is electrically connected to the second electrode of the third gating transistor. The fourth bit line is electrically connected to the second electrode of the fourth gating transistor. The plurality of second supply voltage lines are electrically connected to a second electrode of the fifth transistor and a second electrode of the sixth transistor. The plurality of second ground lines are electrically connected to a second electrode of the seventh transistor and a second electrode of the eighth transistor. In the orthographic projection toward the reference plane, the third bit line overlaps the second electrode of the third gating transistor, the fourth bit line overlaps the second electrode of the fourth gating transistor, the plurality of second supply voltage lines overlap the second electrode of the fifth transistor and the second electrode of the sixth transistor, and the plurality of second ground lines overlap the second electrode of the seventh transistor and the second electrode of the eighth transistor.

According to a second aspect, an electronic device is provided. The electronic device includes a circuit board and the memory according to any one of the foregoing embodiments. The memory is electrically connected to the circuit board.

For technical effect achieved in any design manner in the second aspect, refer to the technical effect achieved in different design manners in the first aspect. Details are not described herein again.

### BRIEF DESCRIPTION OF DRAWINGS

To describe technical solutions in this application more clearly, the following briefly describes accompanying drawings for describing some embodiments of this application. It is clear that the accompanying drawings in the following descriptions are merely accompanying drawings in some embodiments of this application. A person of ordinary skill in the art may further derive other drawings from these accompanying drawings. In addition, the accompanying drawings in the following descriptions may be considered as diagrams, and are not intended to limit an actual size of a product, an actual procedure of a method, an actual time sequence of a signal, and the like in embodiments of this application.
FIG. 1 is a circuit diagram of a memory according to an embodiment of this application;
FIG. 2 is a diagram of a structure of a memory according to an embodiment of this application;
FIG. 3 is a diagram of a structure of another memory according to an embodiment of this application;
FIG. 4 is a circuit diagram of another memory according to an embodiment of this application;
FIG. 5 is a diagram of a structure of still another memory according to an embodiment of this application;
FIG. 6 is a top view of a first circuit structure layer according to an embodiment of this application;
FIG. 7 is a top view of a second circuit structure layer according to an embodiment of this application;
FIG. 8 is a three-dimensional diagram of a structure of a memory cell according to an embodiment of this application;
FIG. 9 is a top view of a memory cell according to an embodiment of this application;
FIG. 10 is a diagram of a structure of yet still another memory according to an embodiment of this application;
FIG. 11 is a diagram of a structure of yet still another memory according to an embodiment of this application;
FIG. 12 is a three-dimensional diagram of a structure of a memory according to an embodiment of this application;
FIG. 13 is a diagram of a structure of yet still another memory according to an embodiment of this application;
FIG. 14 is a circuit diagram of still another memory according to an embodiment of this application;
FIG. 15 is a diagram of a structure of yet still another memory according to an embodiment of this application;
FIG. 16 is a top view of another first circuit structure layer according to an embodiment of this application;
FIG. 17 is a top view of another second circuit structure layer according to an embodiment of this application;
FIG. 18 is a top view of another memory cell according to an embodiment of this application;
FIG. 19 is a top view of still another memory cell according to an embodiment of this application;
FIG. 20 is a diagram of a structure of yet still another memory according to an embodiment of this application;
FIG. 21 is a diagram of a structure of yet still another memory according to an embodiment of this application; and
FIG. 22 is a diagram of a structure of an electronic device according to an embodiment of this application.

### DESCRIPTION OF EMBODIMENTS

The following describes technical solutions in embodiments of this application with reference to the accompanying drawings in embodiments of this application. In descriptions of this application, unless otherwise specified, "/" indicates an "or" relationship between associated objects. For example, A/B may indicate A or B. In this application, "and/or" describes only an association relationship between associated objects, and indicates that three relationships may exist. For example, A and/or B may indicate the following three cases: Only A exists, both A and B exist, and only B exists, where A and B may be singular or plural.

In the descriptions of this application, unless otherwise specified, "a plurality of" means two or more than two. "At least one of the following items (pieces)" or a similar expression thereof means any combination of these items, including any combination of singular items (pieces) or plural items (pieces). For example, at least one of a, b, or c may indicate a, b, c, a and b, a and c, b and c, or a, b, and c, where a, b, and c may be singular or plural.

To clearly describe the technical solutions in embodiments of this application, terms such as "first" and "second" are used in embodiments of this application to distinguish between same items or similar items that have basically the same functions and purposes. A person skilled in the art may understand that the terms such as "first" and "second" do not limit a quantity or an execution sequence, and the terms such as "first" and "second" do not indicate a definite difference.

In embodiments of this application, the word "example" or "for example" is used to represent giving an example, an illustration, or a description. Any embodiment or design scheme described as an "example" or "for example" in embodiments of this application should not be explained as being more preferred or having more advantages than another embodiment or design scheme. Exactly, use of the word like "example" or "for example" is intended to present a related concept in a specific manner for ease of understanding.

FIG. 1 is a circuit diagram of an SRAM. The SRAM may include a plurality of memory cells, a first bit line BL, a second bit line BL', a word line WL, a supply voltage line V_{DD}, and ground lines GND. The first bit line BL and the second bit line BL' are configured to write data into the plurality of memory cells, or read data stored in the plurality of memory cells.

As shown in FIG. 1, the memory cell includes six transistors Q1 to Q6. The transistors Q1 to Q6 are all metal-oxide-semiconductor field-effect transistors. However, the transistors Q1 to Q6 have different polarities. To be specific, the transistor Q1, the transistor Q2, the transistor Q5, and the transistor Q6 are N-type transistors, and the transistor Q3 and the transistor Q4 are P-type transistors.

The transistors Q1 to Q4 constitute an SR latch (set-reset latchch) that is configured to memorize 1-bit binary code. The transistor Q5 and the transistor Q6 are gating transistors, and are configured to control a connection between the SR latch, and the first bit line BL and the second bit line BL'. Under control of the same word line WL, the transistor Q5 and the transistor Q6 are conducted or cut off at the same time.

The transistors Q1 to Q6 each include a first electrode, a second electrode, and a gate. The first electrode is one of a source and a drain, and the second electrode is the other of the source and the drain. In other words, when the first electrode is a source, the second electrode is a drain, or when the first electrode is a drain, the second electrode is a source.

The first electrode of the transistor Q1 is electrically connected to the ground line GND. The second electrode of the transistor Q1 is electrically connected to the first electrode of the transistor Q3. The gate of the transistor Q1 is electrically connected to the gate of the transistor Q3. The second electrode of the transistor Q3 is electrically connected to the supply voltage line V_{DD}. The transistor Q1 and the transistor Q3 constitute a first inverter 110. The first inverter 110 has an input port IN and an output port OUT. The input port IN corresponds to the gate of the transistor Q1 (or the gate of the transistor Q3). The output port OUT corresponds to the second electrode of the transistor Q1 (or the first electrode of the transistor Q3).

The first electrode of the transistor Q2 is electrically connected to the ground line GND. The second electrode of the transistor Q2 is electrically connected to the first electrode of the transistor Q4. The gate of the transistor Q2 is electrically connected to the gate of the transistor Q4. The second electrode of the transistor Q4 is electrically connected to the supply voltage line V_{DD} The transistor Q2 and the transistor Q4 constitute a second inverter 120. The second inverter 120 has an input port IN' and an output port OUT'. The input port IN' corresponds to the gate of the transistor Q2 (or the gate of the transistor Q4). The output port OUT' corresponds to the second electrode of the transistor Q2 (or the first electrode of the transistor Q4).

The first electrode of the transistor Q5 is connected to the first bit line BL. The second electrode of the transistor Q5 is connected to the output port OUT of the first inverter 110 and the input port IN' of the second inverter 120. The gate of the transistor Q5 is connected to the word line WL.

The first electrode of the transistor Q6 is connected to the second bit line BL'. The second electrode of the transistor Q6 is connected to the output port OUT' of the second inverter 120 and the input port IN of the first inverter 110. The gate of the transistor Q6 is connected to the word line WL.

The following briefly describes a working procedure of the memory cell with reference to FIG. 1.

In a write phase, the word line WL receives a high-level signal, and the transistor Q5 and the transistor Q6 are conducted. If a high level is written, the first bit line BL receives a high-level signal, and the second bit line BL' receives a low-level signal. If the output port OUT is at the high level and the output port OUT' is at a low level, in other words, original signals of the output port OUT and the output port OUT' are the same as those of the first bit line BL and the second bit line BL', the signals of the output port OUT and the output port OUT' remain unchanged. If the output port OUT is at the low level and the output port OUT' is at the high level, the signal of the output port OUT is reversed to the high level, and the signal of the output port OUT' is reversed to the low level. Then, the word line WL receives a low-level signal, the transistor Q5 and the transistor Q6 are cut off, and levels of the output port OUT and the output port OUT' into which the signals are written are maintained through a positive feedback of the latch, to complete a write operation. When a low level is written, a write procedure is similar to the write procedure of the high level. Details are not described herein again.

After the write phase, the memory cell is in a static holding state. In this case, in each of the first inverter and the second inverter, only one transistor is conducted, and the other transistor is cut off. For example, when the high level is written into the memory cell (in other words, the output port OUT is at the high level and the output port OUT' is at the low level), in the first inverter 110, the transistor Q3 is conducted and the transistor Q1 is cut off, and in the second inverter 120, the transistor Q2 is conducted and the transistor Q4 is cut off.

In a read phase, the word line WL receives a low-level signal, and the transistor Q5 and the transistor Q6 are cut off. The first bit line BL and the second bit line BL' are pre-charged to a same voltage (for example, the high level), then the word line WL receives a high-level signal, and both the transistor Q5 and the transistor Q6 are conducted. When the SR latch stores the high level (the output port OUT is at the high level and the output port OUT' is at a low level), the first bit line BL is connected to the output port OUT and the level of the output port OUT remains unchanged, and the second bit line BL' is connected to the output port OUT' at the low level via the conducted transistor Q6. Because the second bit line is charged to the high level, the second bit line BL' is discharged and a voltage decreases. In specific duration, the voltage of the second bit line BL' decreases. Because a potential of the first bit line BL almost does not change, a voltage difference is generated between the first bit line BL and the second bit line BL'. The voltage difference increases with time. A read operation is completed by reading the voltage difference.

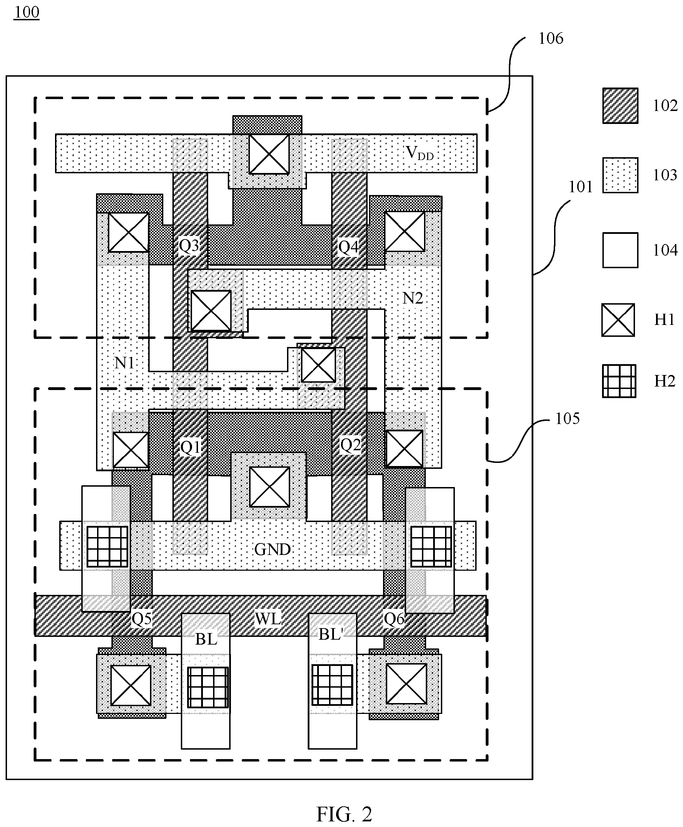

A memory 100 is provided in a related technology based on the circuit diagram shown in FIG. 1. As shown in FIG. 2, the memory 100 includes a substrate 101, and a first conductive layer 102, a second conductive layer 103, and a third conductive layer 104 that are sequentially away from the substrate 101.

It may be understood that, in addition to the foregoing plurality of conductive layers, the memory 100 further includes a plurality of dielectric layers (not shown), and the dielectric layers are located between two adjacent conductive layers, so that the two adjacent conductive layers are insulated.

With reference to FIG. 2, the memory 100 includes a plurality of transistors, a supply voltage line V_{DD}, a ground line GND, a word line WL, a first bit line BL, and a second bit line BL'. Transistors Q1 to Q6 constitute one memory cell. Channels, first electrodes, and second electrodes of the transistors Q1 to Q6 are located in the substrate 101. Gates of the transistors Q1 to Q4 and the word line WL are located in the first conductive layer 102. The transistor Q1 and the transistor Q3 share the gate, and the transistor Q2 and the transistor Q4 share the gate. Parts that are of the word line WL and that overlap the channels of the transistor Q5 and the transistor Q6 are respectively used as gates of the transistor Q5 and the transistor Q6.

The supply voltage line V_{DD} and the ground line GND are located in the second conductive layer 103. The ground line GND passes through a via H1 to connect the first electrode of the transistor Q1 to the first electrode of the transistor Q2. The supply voltage line V_{DD} passes through a via H1 to connect the second electrode of the transistor Q3 to the second electrode of the transistor Q4. The via H1 may be located in a dielectric layer (not shown) between the substrate 101 and the second conductive layer 103.

The second conductive layer 103 further includes a first conductive pattern N1 and a second conductive pattern N2. The first conductive pattern N1 passes through a plurality of vias H1 to be separately electrically connected to the second electrode of the transistor Q1, the first electrode of the transistor Q3, and the gate of the transistor Q2 and the transistor Q4. The second conductive pattern N2 passes through a plurality of vias H1 to be separately electrically connected to the second electrode of the transistor Q2, the first electrode of the transistor Q4, and the gate of the transistor Q3 and the transistor Q1.

The first bit line BL and the second bit line BL' are located in the third conductive layer 104, and respectively pass through a via H2 and a via H1 to connect the first electrode of the transistor Q5 to the first electrode of the transistor Q6. The via H2 may be located in a dielectric layer (not shown) between the second conductive layer 103 and the third conductive layer 104.

The memory 100 includes an N-well region 105 and a P-well region 106. The transistor Q1, the transistor Q2, the transistor Q5, and the transistor Q6 are located in the N-well region 105. The transistor Q3 and the transistor Q4 are located in the P-well region 106.

As shown in FIG. 2, areas occupied by the plurality of transistors in the memory 100 are large, and areas occupied by lines (for example, the supply voltage line V_{DD}, the ground line GND, and the word line WL) and conductive patterns (for example, the first conductive pattern N1 and the second conductive pattern N2) in the memory 100 are also large. In addition, because a plurality of conductive patterns that have corners (namely, the first conductive pattern N1 and the second conductive pattern N2) are formed in the second conductive layer 103, it is not easy to further miniaturize the second conductive layer 203 during preparation, and the second conductive layer 103 has poor repeatability.

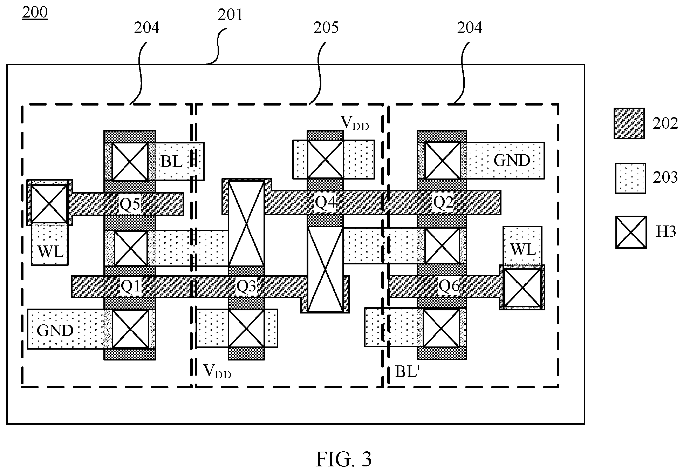

Another memory 200 is further provided in a related technology based on the circuit diagram shown in FIG. 1. As shown in FIG. 3, the memory 200 includes a substrate 201, and a first conductive layer 202 and a second conductive layer 203 that are sequentially away from the substrate 201.

It may be understood that, in addition to the foregoing plurality of conductive layers, the memory 200 further includes a plurality of dielectric layers (not shown), and the dielectric layers are located between two adjacent conductive layers, so that the two adjacent conductive layers are insulated.

The memory 200 includes a plurality of memory cells, a supply voltage line V_{DD}, a ground line GND, a word line WL, a first bit line BL, and a second bit line BL'. In FIG. 3, only one memory cell is used as an example.

Each memory cell includes transistors Q1 to Q6. Channels, first electrodes, and second electrodes of the transistors Q1 to Q6 are located in the substrate 201. Gates of the transistors Q1 to Q6 are all located in the first conductive layer 202. In addition, the transistor Q1 and the transistor Q3 share the gate, and the transistor Q2 and the transistor Q4 share the gate. The supply voltage line V_{DD}, the ground line GND, the word line WL, the first bit line BL, and the second bit line BL' are all located in the second conductive layer 203. The word line WL passes through a via H3 to be separately electrically connected to the gates of the transistor Q5 and the transistor Q6. The first bit line BL passes through a via H3 to be electrically connected to the first electrode of the transistor Q5. The second bit line BL' passes through a via H3 to be electrically connected to the first electrode of the transistor Q6.

For example, the via H3 may be a via in a dielectric layer located between the substrate 201 and the first conductive layer 202, or may be a via in a dielectric layer located between the first conductive layer 202 and the second conductive layer 203, or may be the via in the dielectric layer located between the substrate 201 and the first conductive layer 202 and the via in the dielectric layer located between the first conductive layer 202 and the second conductive layer 203.

The memory 200 includes an N-well region 204 and a P-well region 205. The transistor Q1, the transistor Q2, the transistor Q5, and the transistor Q6 are located in the N-well region 204. The transistor Q3 and the transistor Q4 are located in the P-well region 205.

With reference to FIG. 3, although a conductive pattern that has a corner does not exist in the memory 200, because the plurality of transistors have different polarities, a plurality of N-well regions 204 and P-well regions 205 still need to be formed in the memory 200. As a result, specific space is required in the memory 200 to separate the N-well region 204 from the P-well region 205, and consequently an area occupied by the memory 200 is large.

In addition to the large occupation areas, the transistors of the foregoing two memories have different polarities. Therefore, the foregoing plurality of transistors need to be formed on a bipolar channel material like a silicon-based material. However, it is not easy to perform 3D integration on the bipolar channel material using a back-end-of-line process or a stacking process. As a result, both entire areas occupied by the memories are large.

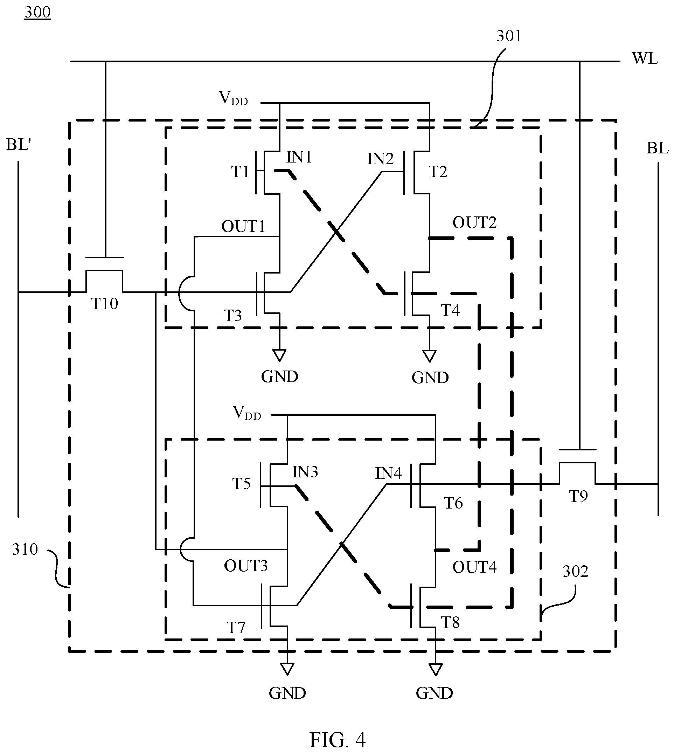

In view of this, embodiments of this application provide a memory 300. The memory 300 includes a plurality of memory cells 310, a first bit line BL, a second bit line BL', supply voltage lines V_{DD}, and ground lines GND. FIG. 4 is a circuit diagram of the memory 300 according to an embodiment of this application. FIG. 4 shows one of the plurality of memory cells 310 of the memory 300.

The memory cell 310 includes a first inverter 301 and a second inverter 302. The first inverter 301 includes a first input port IN1, a second input port IN2, a first output port OUT1, and a second output port OUT2. The second inverter 302 includes a third input port IN3, a fourth input port IN4, a third output port OUT3, and a fourth output port OUT4.

With reference to FIG. 4, the first input port IN1 of the first inverter 301 is electrically connected to the fourth output port OUT4 of the second inverter 302. The second input port IN2 of the first inverter 301 is electrically connected to the third output port OUT3 of the second inverter 302. The third input port IN3 of the second inverter 302 is electrically connected to the second output port OUT2 of the first inverter 301. The fourth input port IN4 of the second inverter 302 is electrically connected to the first output port OUT1 of the first inverter 301. In this way, the first inverter 301 and the second inverter 302 are cascaded to form a latch.

In the circuit diagram provided in FIG. 4, a black dashed line represents a signal line conjugated with a black solid line. To be specific, signals at the first input port IN1 and the second input port IN2 are conjugated and inverted, signals at the first output port OUT1 and the second output port OUT2 are conjugated and inverted, signals at the third input port IN3 and the fourth input port IN4 are conjugated and inverted, and signals at the third output port OUT3 and the fourth output port OUT4 are also conjugated and inverted.

It may be understood that, at an intersection of the black dashed line and the black solid line, signals of the black dashed line and the black solid line are not communicated.

In some examples, the first inverter 301 may include a first transistor T1, a second transistor T2, a third transistor T3, and a fourth transistor T4. The first transistor T1, the second transistor T2, the third transistor T3, and the fourth transistor T4 each include a first electrode, a gate, and a second electrode. The first electrode is one of a source and a drain, and the second electrode is the other of the source and the drain. First electrodes of different transistors may be all sources or all drains, or may be a source and a drain.

For example, the gate of the first transistor T1 is electrically connected to the gate of the fourth transistor T4, the first electrode of the first transistor T1 is electrically connected to the supply voltage line V_{DD}, the second electrode of the first transistor T1 is electrically connected to the second electrode of the third transistor T3, and the first electrode of the third transistor T3 is electrically connected to the ground line GND. The first transistor T1 and the third transistor T3 constitute a path.

The gate of the second transistor T2 is electrically connected to the gate of the third transistor T3, the first electrode of the second transistor T2 is electrically connected to the supply voltage line V_{DD}, the second electrode of the second transistor T2 is electrically connected to the second electrode of the fourth transistor T4, and the first electrode of the fourth transistor T4 is electrically connected to the ground line GND. The second transistor T2 and the fourth transistor T4 constitute another path.

In some examples, the second inverter 302 may include a fifth transistor T5, a sixth transistor T6, a seventh transistor T7, and an eighth transistor T8. The fifth transistor T5, the sixth transistor T6, the seventh transistor T7, and the eighth transistor T8 each include a first electrode, a gate, and a second electrode. The first electrode is one of a source and a drain, and the second electrode is the other of the source and the drain. First electrodes of different transistors may be all sources or all drains, or may be a source and a drain.

For example, the gate of the fifth transistor T5 is electrically connected to the gate of the eighth transistor T8, the first electrode of the fifth transistor T5 is electrically connected to the first electrode of the seventh transistor T7, the second electrode of the fifth transistor T5 is electrically connected to the supply voltage line V_{DD}, and the second electrode of the seventh transistor T7 is electrically connected to the ground line GND. The fifth transistor T5 and the seventh transistor T7 constitute still another path.

The gate of the sixth transistor T6 is electrically connected to the gate of the seventh transistor T7, the first electrode of the sixth transistor T6 is electrically connected to the first electrode of the eighth transistor T8, the second electrode of the sixth transistor T6 is electrically connected to the supply voltage line V_{DD}, and the second electrode of the eighth transistor T8 is electrically connected to the ground line GND. The sixth transistor T6 and the eighth transistor T8 constitute still another path.

Still with reference to FIG. 4, the memory cell 310 further includes a first gating transistor T9 and a second gating transistor T10. The first gating transistor T9 and the second gating transistor T10 are configured to control a connection between the latch, and the first bit line BL and the second bit line BL'. The first gating transistor T9 and the second gating transistor T10 are controlled by a same word line WL, and are conducted or cut off at the same time. The first gating transistor T9 and the second gating transistor T10 each include a first electrode, a gate, and a second electrode. The first electrode is one of a source and a drain, and the second electrode is the other of the source and the drain.

For example, the first electrode of the first gating transistor T9 is electrically connected to the first bit line BL. The second electrode of the first gating transistor T9 is electrically connected to the first output port OUT1 of the first inverter 301 and the fourth input port IN4 of the second inverter 302. To be specific, the second electrode of the first gating transistor T9 is electrically connected to the gate of the sixth transistor T6, the gate of the seventh transistor T7, the second electrode of the first transistor T1, and the second electrode of the third transistor T3.

For example, the second electrode of the second gating transistor T10 is electrically connected to the second bit line BL'. The first electrode of the second gating transistor T10 is electrically connected to the second input port IN2 of the first inverter 301 and the third output port OUT3 of the second inverter 302. To be specific, the first electrode of the second gating transistor T10 is electrically connected to the gate of the third transistor T3, the gate of the second transistor T2, the first electrode of the fifth transistor T5, and the first electrode of the seventh transistor T7.

A plurality of transistors of the plurality of memory cells 310 provided in the foregoing embodiment of this application have a same polarity. In FIG. 4, for example, the plurality of transistors are all N-type transistors. In some other examples, the plurality of transistors in the memory cell 310 may be all P-type transistors.

The following briefly describes a working procedure of the memory cell 310 with reference to the circuit diagram provided in FIG. 4.

The working procedure of the memory cell 310 includes a write procedure and a read procedure. In the write procedure, the word line WL receives a high-level signal, and the first gating transistor T9 and the second gating transistor T10 are conducted. When a high level is written, the first bit line BL receives the high-level signal, and the second bit line BL' receives a low-level signal. If a voltage of the second electrode of the first gating transistor T9 (or the first output port OUT1 of the first inverter) is a high level, and a voltage of the first electrode of the second gating transistor T10 (or the third output port OUT3 of the second inverter) is a low level, the voltage of the second electrode of the first gating transistor T9 and the voltage of the first electrode of the second gating transistor T10 remain unchanged. If the voltage of the second electrode of the first gating transistor T9 is a low level, and the voltage of the first electrode of the second gating transistor T10 is a high level, the voltage of the second electrode of the first gating transistor T9 and the voltage of the first electrode of the second gating transistor T10 are reversed. Then, the word line WL receives a low-level signal, and the first gating transistor T9 and the second gating transistor T10 are cut off. A write procedure of a low level is similar to the foregoing write procedure of the high level. Details are not described herein again.

In the read procedure, the word line WL receives a low-level signal, and the first gating transistor T9 and the second gating transistor T10 are cut off. After the first bit line BL and the second bit line BL' are pre-charged to a same voltage (for example, pre-charged to the high level), the word line WL receives a high-level signal, and the first gating transistor T9 and the second gating transistor T10 are conducted. When the latch stores the high level (the voltage of the second electrode of the first gating transistor T9 is the high level, and the voltage of the first electrode of the second gating transistor T10 is the low level), voltages of the first electrode and the second electrode of the first gating transistor T9 are the same, and voltages of the first electrode and the second electrode of the second gating transistor T10 are different. The second bit line BL' is discharged, and the voltage decreases. A voltage difference is generated between the first bit line BL and the second bit line BL', and the voltage difference is read, to complete a read operation.

After a write operation is completed, the memory cell 310 enters a static signal holding phase. In this case, in any one of parallel paths of the latch, only one transistor is conducted, and the other transistor is cut off. For example, when the plurality of transistors in the latch are all N-type transistors, after the high level is written, the first transistor T1, the fourth transistor T4, the sixth transistor T6, and the seventh transistor T7 are all conducted, and the second transistor T2, the third transistor T3, the fifth transistor T5, and the eighth transistor T8 are all cut off.

It may be understood that, when the plurality of transistors in the memory cell 310 may be all P-type transistors, the first gating transistor T9 and the second gating transistor T10 are conducted when the word line WL transmits the low-level signal, and are cut off when the word line WL transmits the high-level signal. In a same working phase, a signal of the first output port OUT1 of the first inverter including the P-type transistors is inverted with a signal of the first output port OUT1 of the first inverter including the N-type transistors. A signal of the second output port OUT2 of the first inverter including the P-type transistors is inverted with a signal of the second output port OUT2 of the first inverter including the N-type transistors. A signal of the third output port OUT3 of the second inverter including the P-type transistors is inverted with a signal of the third output port OUT3 of the second inverter including the N-type transistors. A signal of the fourth output port OUT4 of the second inverter including the P-type transistors is inverted with a signal of the fourth output port OUT4 of the second inverter including the N-type transistors.

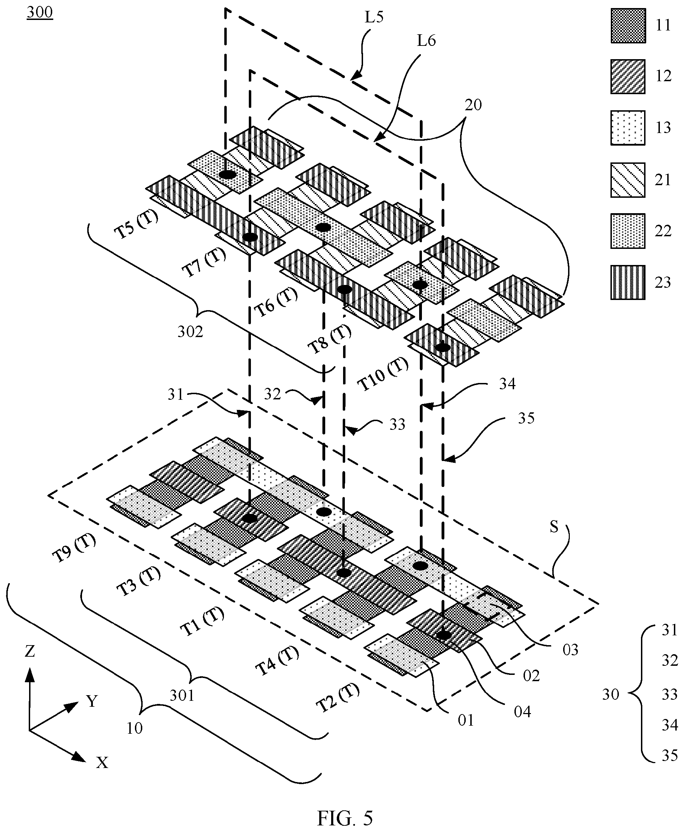

FIG. 5 is a diagram of a structure of the memory 300 according to an embodiment of this application. The memory 300 includes a first circuit structure layer 10, a second circuit structure layer 20, and a plurality of interconnection structures 30. The first circuit structure layer 10 includes the first inverter 301. The second circuit structure layer 20 is stacked with the first circuit structure layer 10, and the second circuit structure layer 20 includes the second inverter 302. The interconnection structure 30 is located between the first circuit structure layer 10 and the second circuit structure layer 20.

The first inverter 301 and the second inverter 302 each include a plurality of transistors T. The plurality of transistors T of the first inverter 301 and the plurality of transistors T of the second inverter 302 have a same polarity. The plurality of transistors T of the first inverter 301 and the plurality of transistors T of the second inverter 302 are all sequentially arranged in a first direction X parallel to a reference plane S. The reference plane S is a plane on which the lower surface of the first circuit structure layer 10 is located. Orthographic projections of the plurality of transistors T of the first inverter 301 on the reference plane S overlap orthographic projections of the plurality of transistors T of the second inverter 302 on the reference plane S. The first inverter 301 is electrically connected to the second inverter 302 through the plurality of interconnection structures 30.

In some examples, a plurality of transistors T of the first inverter 301 and the second inverter 302 may be all N-type transistors. In some other examples, the plurality of transistors T of the first inverter 301 and the second inverter 302 may be all P-type transistors.

In some examples, the plurality of transistors T of the first inverter 301 and the second inverter 302 may be single-gate transistors, double-gate transistors, fin field-effect transistors (fin field-effect transistors, FinFETs), gate-all-around field-effect transistors (gate-all-around field-effect transistors, GAAFETs), or the like. The structures of the plurality of transistors T of the first inverter 301 and the second inverter 302 are not limited in embodiments of this application. In FIG. 4, for example, the transistors T are single-gate transistors.

In the memory 300 provided in this embodiment of this application, the plurality of transistors T of the first inverter 301 and the second inverter 302 have the same polarity. Therefore, in a process of preparing the memory 300, the plurality of transistors T can be prepared from a unipolar channel material (for example, an oxide semiconductor material or an organic semiconductor material). In this way, the memory 300 can be prepared using a back-end-of-line process or a stacking process. This simplifies a process, implements 3D integration of the memory 300 with a logic device that controls the memory 300, reduces an area occupied by the memory 300, and improves area utilization of the memory.

The plurality of transistors T have the same polarity, so that the plurality of transistors can be further compactly arranged, and extra space does not need to be used in the memory cell to separate transistors of different polarities. This can further reduce an area occupied by the memory cell 310, thereby reducing the area occupied by the memory 300, and improving the area utilization of the memory.

Compared with a case in which the entire memory cell is disposed in a same circuit structure layer, in this embodiment of this application, the first inverter 301 of the memory cell 310 is disposed in the first circuit structure layer 10, and the second inverter 302 is disposed in the second circuit structure layer 20. This implements 3D stacking of the memory cell, thereby further improving the area utilization of the memory.

In addition, in the memory 300 provided in this embodiment of this application, the plurality of transistors T of the first inverter 301 are sequentially arranged in the first direction X. The plurality of transistors T are regularly arranged, so that an area occupied by the first inverter 301 in the first circuit structure layer 10 can be small. The plurality of transistors T of the second inverter 302 are sequentially arranged in the first direction X. The plurality of transistors T are regularly arranged, so that an area occupied by the second inverter 302 in the second circuit structure layer 20 can be small. The areas occupied by the first inverter 301 and the second inverter 302 are small, so that an area of an orthographic projection of the memory cell 310 on the reference plane S is also small.

The orthographic projections of the plurality of transistors T of the first inverter 301 on the reference plane S overlap the orthographic projections of the plurality of transistors T of the second inverter 302 on the reference plane S. In this way, on one hand, it is conductive to implementation of electrically connecting the first inverter 301 to the second inverter 302 through the plurality of interconnection structures 30, to simplify a connection form between the first inverter 301 and the second inverter 302. On the other hand, an area occupied by each memory cell 310 can be further reduced, to improve the area utilization of the memory 300.

As shown in FIG. 5, in some embodiments, the transistor T includes a first electrode 01, a gate 02, and a second electrode 03 that are sequentially arranged in a second direction Y. The second direction Y is parallel to the reference plane S and perpendicular to the first direction X. In an orthographic projection toward the reference plane S, the gate 02 of the transistor T of the first inverter 301 overlaps the first electrode 01 of the transistor T of the second inverter 302, and the second electrode 03 of the transistor T of the first inverter 301 overlaps the gate 02 of the transistor T of the second inverter 302.

In this way, an overlapping area between the transistor of the first inverter 301 and the transistor of the second inverter 302 is large, and the area occupied by the memory cell 310 is small. In addition, the gate 02 of the transistor T of the first inverter 301 overlaps the first electrode 01 of the transistor T of the second inverter 302, and the second electrode 03 of the transistor T of the first inverter 301 overlaps the gate 02 of the transistor T of the second inverter 302. This further helps make the interconnection structure 30 perpendicular to the first circuit structure layer 10 and the second circuit structure layer 20, and simplifies the plurality of interconnection structures, so that an orthographic projection of the interconnection structure 30 on the reference plane S is small, and an area occupied by the interconnection structure 30 is small.

As shown in FIG. 5, in some embodiments, the first circuit structure layer 10 may include a first active layer 11, a first gate layer 12, a first source and drain electrode layer 13, and a plurality of dielectric layers that stacked.

The plurality of dielectric layers may include a dielectric layer located on a side that is of the first active layer 11 and that is away from the first gate layer 12, a dielectric layer that insulates the first active layer 11 from the first gate layer 12, a dielectric layer that insulates the first source and drain electrode layer 13 from the first gate layer 12, and the like.

Gates 02 of the plurality of transistors T of the first inverter 301 may be located in the first gate layer 12, and first electrodes 01 and second electrodes 03 of the plurality of transistors T of the first inverter 301 may be located in the first source and drain electrode layer 13. The plurality of transistors T of the first inverter 301 may further include channels 04. The channels 04 may be formed in the first active layer 11, and are in a same transistor T. An orthographic projection of the channel 04 on the reference plane S overlaps an orthographic projection of the gate 02 on the reference plane S. The first electrode 01 and the second electrode 03 of the transistor T may pass through the dielectric layer to be electrically in contact with the channel 04.

With reference to FIG. 5, in some embodiments, the second circuit structure layer 20 may include a second active layer 21, a second gate layer 22, a second source and drain electrode layer 23, and a plurality of dielectric layers that are stacked.

The plurality of dielectric layers may include a dielectric layer located on a side that is of the second active layer 21 and that is away from the second gate layer 22, a dielectric layer (not shown) that insulates the second active layer 21 from the second gate layer 22, and a dielectric layer (not shown) that insulates the second source and drain electrode layer 23 from the second gate layer 22.

Gates 02 of the plurality of transistors T of the second inverter 302 may be located in the second gate layer 22, and first electrodes 01 and second electrodes 03 of the plurality of transistors T of the second inverter 302 may be located in the second source and drain electrode layer 23. The plurality of transistors T of the second inverter 302 may further include channels 04. The channels 04 may be formed in the second active layer 21, and are in a same transistor T. An orthographic projection of the channel 04 on the reference plane S overlaps an orthographic projection of the gate 02 on the reference plane S. The first electrode 01 and the second electrode 03 of the transistor T may pass through the dielectric layer to be in contact with the channel 04.

Still with reference to FIG. 5, in some embodiments, a dielectric layer may also exist between the first circuit structure layer 10 and the second circuit structure layer 20. The plurality of interconnection structures 30 may pass through the dielectric layer (not shown) to connect the first inverter 301 in the first circuit structure layer 10 to the second inverter 302 in the second circuit structure layer 20.

It may be understood that FIG. 5 shows merely a possible structure of the memory 300 in this embodiment of this application, and the structures of the plurality of transistors T of the memory 300 are not limited thereto.

Still with reference to FIG. 5, in some embodiments, in the orthographic projection toward the reference plane S, the first electrode 01 of the transistor T of the first inverter 301 is staggered with the second electrode 03 of the transistor T of the second inverter 302. Through such a disposal, it can be convenient to electrically connect the plurality of transistors T of the first inverter 301 and the second inverter 302 to other lines (for example, the supply voltage line V_{DD} and the ground line GND).

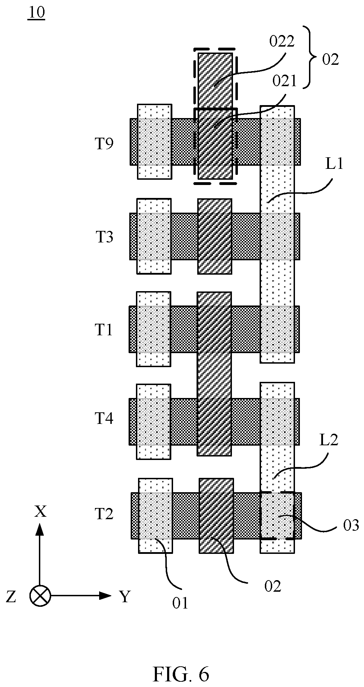

As shown in FIG. 6, the first inverter 301 includes the first transistor T1, the second transistor T2, the third transistor T3, and the fourth transistor T4. In the first direction X, the third transistor T3, the first transistor T1, the fourth transistor T4, and the second transistor T2 are sequentially arranged. The first transistor T1 and the fourth transistor T4 share the gate. The first circuit structure layer 10 further includes a first connection line L1 and a second connection line L2. A second electrode 03 of the third transistor T3 is electrically connected to a second electrode 03 of the first transistor T1 through the first connection line L1. A second electrode 03 of the fourth transistor T4 is electrically connected to a second electrode 03 of the second transistor T2 through the second connection line L2.

As shown in FIG. 6, the first connection line L1 and the second connection line L2 may extend in the first direction X. In this way, the first connection line L1 and the second connection line L2 have simple shapes and are easy to prepare, and areas occupied by the first connection line L1 and the second connection line L2 can be small.

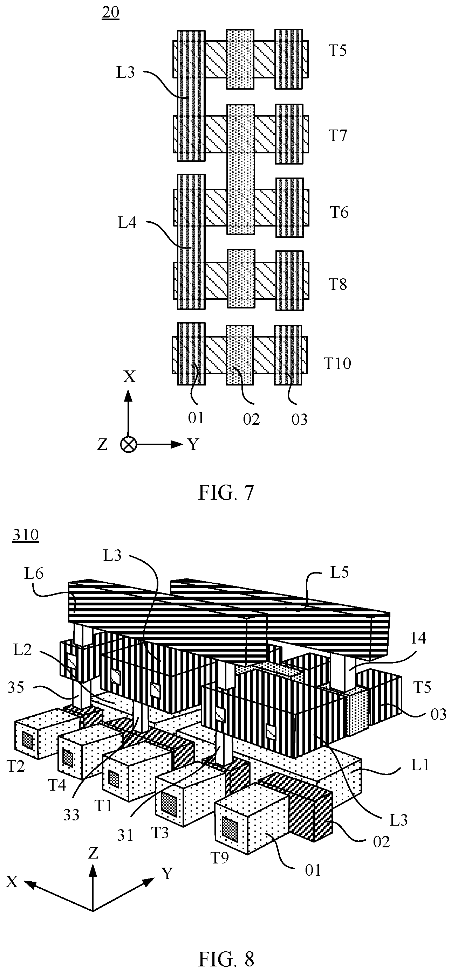

As shown in FIG. 7, the second inverter 302 includes the fifth transistor T5, the sixth transistor T6, the seventh transistor T7, and the eighth transistor T8. In the first direction X, the fifth transistor T5, the seventh transistor T7, the sixth transistor T6, and the eighth transistor T8 are sequentially arranged. The sixth transistor T6 and the seventh transistor T7 share the gate.

The second circuit structure layer 20 further includes a third connection line L3 and a fourth connection line L4. A first electrode 01 of the fifth transistor T5 is electrically connected to a first electrode 01 of the seventh transistor T7 through the third connection line L3. A first electrode 01 of the sixth transistor T6 is electrically connected to a first electrode 01 of the eighth transistor T8 through the fourth connection line L4.

In some examples, as shown in FIG. 7, the third connection line L3 and the fourth connection line L4 may extend in the first direction X. In this way, the third connection line L3 and the fourth connection line L4 have simple shapes and are easy to prepare, and areas occupied by the third connection line L3 and the fourth connection line L4 can be small.

Based on the arrangement manner of the transistors of the first inverter 301 and the second inverter 302, in some embodiments, with reference to FIG. 5, the plurality of interconnection structures 30 include a first interconnection structure 31, a second interconnection structure 32, a third interconnection structure 33, and a fourth interconnection structure 34.

A gate 02 of the third transistor T3 is electrically connected to the first electrode 01 of the seventh transistor T7 through the first interconnection structure 31. A gate 02 of the seventh transistor T7 is electrically connected to the first connection line L1 through the second interconnection structure 32. A gate 02 of the first transistor T1 is electrically connected to the fourth connection line L4 through the third interconnection structure 33. A gate 02 of the eighth transistor T8 is electrically connected to the second connection line L2 through the fourth interconnection structure 34.

FIG. 8 is a three-dimensional diagram of the memory cell 310 according to an embodiment of this application. With reference to FIG. 5 and FIG. 8, in the memory 300 provided in this embodiment of this application, the first interconnection structure 31, the second interconnection structure 32, the third interconnection structure 33, and the fourth interconnection structure 34 may be perpendicular to the first circuit structure layer 10 and the second circuit structure layer 20. In this way, structures of the plurality of interconnection structures are simple, so that an orthographic projection of the interconnection structure 30 on the reference plane S is small, and the area occupied by the interconnection structure 30 is small.

Still with reference to FIG. 5, in some embodiments, the first circuit structure layer 10 further includes a first gating transistor T9. In the first direction X, the first gating transistor T9 is located on a side that is of the third transistor T3 and that is away from the first transistor T1. The second circuit structure layer 20 further includes a second gating transistor T10. In the first direction X, the second gating transistor T10 is located on a side that is of the eighth transistor T8 and that is away from the sixth transistor T6.

The first gating transistor T9 and the second gating transistor T10 include first electrodes 01, gates 02, and second electrodes 03 that are sequentially arranged in the second direction Y. The second electrode 03 of the first gating transistor T9 is electrically connected to the first connection line L1.

When the second circuit structure layer 20 further includes the second gating transistor T10, as shown in FIG. 5, the plurality of interconnection structures 30 may further include a fifth interconnection structure 35. The first electrode 01 of the second gating transistor T10 is electrically connected to the gate 02 of the second transistor T2 through the fifth interconnection structure 35.

In some embodiments, as shown in FIG. 5 and FIG. 8, the memory 300 further includes a fifth connection line L5 and a sixth connection line L6. The fifth connection line L5 and the sixth connection line L6 are located on a side that is of the second circuit structure layer 20 and that is away from the first circuit structure layer 10.

The fifth connection line L5 is electrically connected to a gate 02 of the fifth transistor T5 and the gate 02 of the eighth transistor T8. The sixth connection line L6 and the third connection line L3 are electrically connected to the first electrode 01 of the second gating transistor T10. In the orthographic projection toward the reference plane S, the fifth connection line L5 overlaps the gate of the fifth transistor T5 and the gate 02 of the eighth transistor T8, and the sixth connection line L6 overlaps the first electrode 01 of the seventh transistor T7 and the first electrode 01 of the second gating transistor T10. In this way, the area occupied by the memory cell 310 can be further reduced, and an integration level and the area utilization of the memory 300 are improved.

In some examples, both the fifth connection line L5 and the sixth connection line L6 may extend in the first direction X. In this way, the fifth connection line L5 and the sixth connection line L6 have simple shapes and are easy to prepare, and areas occupied by the fifth connection line L5 and the sixth connection line L6 can be small.

In some examples, the fifth connection line L5 and the sixth connection line L6 may be located at a same layer. In this case, materials of the fifth connection line L5 and the sixth connection line L6 may be the same. In this way, the fifth connection line L5 and the sixth connection line L6 can be prepared at the same time. This simplifies a preparation process of the memory cell 310, and reduces preparation costs of the memory cell 310.

It may be understood that, to insulate the fifth connection line L5 and the sixth connection line L6 from the second circuit structure layer 20, a dielectric layer (not shown) may be formed between the fifth connection line and the sixth connection line L6, and the second circuit structure layer 20.

As shown in FIG. 8, the memory 300 may include a plurality of conductive pillars 14. The plurality of conductive pillars 14 may be perpendicular to the first circuit structure layer 10 and the second circuit structure layer 20. One end of the fifth connection line L5 may be electrically connected to the gate of the fifth transistor T5 through one conductive pillar 14, and the other end of the fifth connection line L5 may overlap the gate 02 of the eighth transistor T8 through another conductive pillar 14. One end of the sixth connection line L6 may be electrically connected to the first electrode 01 of the seventh transistor T7 through still another conductive pillar 14, and the other end of the sixth connection line L6 may be electrically connected to the first electrode 01 of the second gating transistor T10 through yet still another conductive pillar 14.

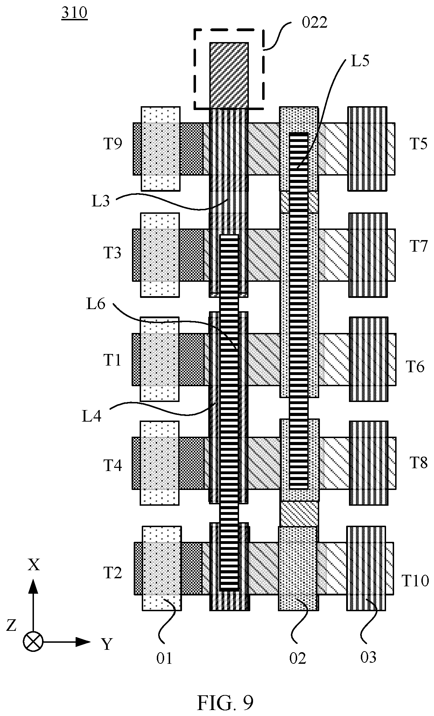

FIG. 9 is a top view of the memory cell 310 according to an embodiment of this application. With reference to FIG. 6 and FIG. 9, in some embodiments, the gate 02 of the first gating transistor T9 includes a first part 021 and a second part 022. The second part 022 is away from the third transistor T3 relative to the first part 021. In the orthographic projection toward the reference plane S, the first part 021 overlaps the first electrode 01 of the fifth transistor T5, and the second part 022 does not overlap the first electrode 01 of the fifth transistor T5. In this way, the second part 022 is not blocked by the first electrode 01 of the fifth transistor T5, so that a connection between the gate of the first gating transistor T9 and the word line WL can be easily implemented.

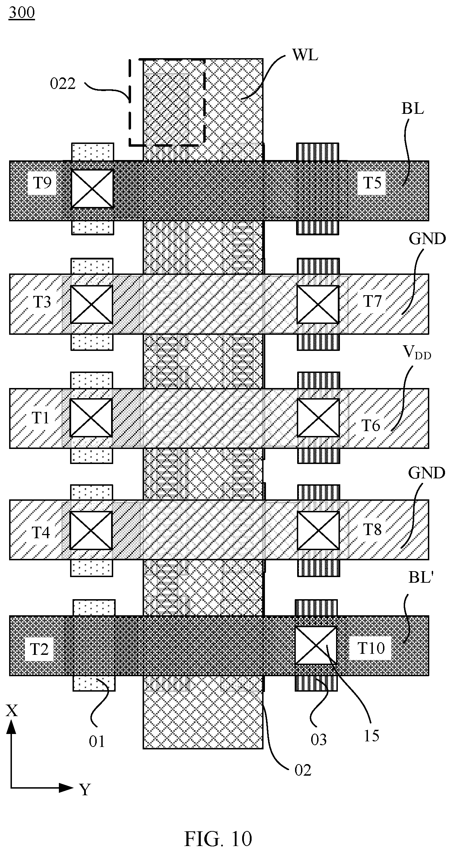

In some embodiments, as shown in FIG. 10, the memory 300 further includes the word line WL. The word line WL is located on the side that is of the second circuit structure layer 20 and that is away from the first circuit structure layer 10, and the word line WL extends in the first direction X. The word line WL is electrically connected to the gate 02 of the first gating transistor T9 and the gate 02 of the second gating transistor T10. In the orthographic projection toward the reference plane S, the word line WL overlaps the second part 022 and the gate 02 of the second gating transistor T10.

It may be understood that, to insulate the word line WL from a component in the second circuit structure layer 20, a dielectric layer (not shown) may be disposed between the word line WL and the second circuit structure layer 20.

In this embodiment of this application, the word line WL extends in the first direction X, so that the word line WL has a simple shape and is easy to prepare, and an area occupied by the word line WL is reduced. In addition, the word line WL overlaps the second part 022 and the gate 02 of the second gating transistor T10, so that the word line WL can further pass through a via in the dielectric layer to be electrically connected to the second part 022 and the gate 02 of the second gating transistor T10. This simplifies the structure of the memory 300, reduces the area occupied by the memory 300, and improves storage density and the area utilization of the memory 300.

Still with reference to FIG. 10, the memory 300 may further include the first bit line BL and the second bit line BL'. The first bit line BL and the second bit line BL' are located on the side that is of the second circuit structure layer 20 and that is away from the first circuit structure layer 10, and extend in the second direction Y.

The first bit line BL is electrically connected to the first electrode 01 of the first gating transistor T9. The second bit line BL' is electrically connected to the second electrode 03 of the second gating transistor T10. In the orthographic projection toward the reference plane S, the first bit line BL overlaps the first electrode 01 of the first gating transistor T9, and the second bit line BL' overlaps the second electrode 03 of the second gating transistor T10.

It may be understood that, to insulate the first bit line BL and the second bit line BL' from the component in the second circuit structure layer 20, a dielectric layer (not shown) may be disposed between the first bit line BL and the second bit line BL', and the second circuit structure layer 20.

In some examples, the first bit line BL and the second bit line BL' may be located at a same layer. In this case, materials of the first bit line BL and the second bit line BL' may be the same. In this way, the first bit line BL and the second bit line BL' can be prepared at the same time. This simplifies a preparation process of the memory 300, and reduces preparation costs of the memory 300.

In this embodiment of this application, in the orthographic projection toward the reference plane S, the first bit line BL overlaps the first electrode 01 of the first gating transistor T9, and the second bit line BL' overlaps the second electrode 03 of the second gating transistor T10. In this way, the first bit line BL can pass through a via 15 in the dielectric layer to be electrically connected to the first electrode 01 of the first gating transistor T9, and the second bit line BL' can pass through a via 15 in the dielectric layer to be electrically connected to the second electrode 03 of the second gating transistor T10. The area occupied by the memory 300 can be smaller, so that the storage density of the memory 300 can be improved.

In some embodiments, the first bit line BL and the second bit line BL' may be located on a side that is of the word line WL and that is away from the second circuit structure layer 20. In some other embodiments, the word line WL may be located on sides that are of the first bit line BL and the second bit line BL' and that are away from the second circuit structure layer 20.

The memory 300 further includes a plurality of supply voltage lines V_{DD} and a plurality of ground lines GND. In some embodiments, as shown in FIG. 10, the plurality of supply voltage lines V_{DD} and the plurality of ground lines GND may be located on the side that is of the second circuit structure layer 20 and that is away from the first circuit structure layer 10, and extend in the second direction Y.

In the orthographic projection toward the reference plane S, the supply voltage line V_{DD} overlaps a first electrode 01 of the first transistor T1, a second electrode 03 of the fifth transistor T5, a second electrode 03 of the sixth transistor T6, and a first electrode 01 of the second transistor T2, and the ground line GND overlaps a first electrode 01 of the third transistor T3, a second electrode 03 of the seventh transistor T7, a first electrode 01 of the fourth transistor T4, and a second electrode 03 of the eighth transistor T8.

In this way, the supply voltage line V_{DD} can pass through a via 15 to be electrically connected to the first electrode 01 of the first transistor T1, the second electrode 03 of the fifth transistor T5, the second electrode 03 of the sixth transistor T6, and the first electrode 01 of the second transistor T2, and the ground line GND can pass through a via 15 to be electrically connected to the first electrode 01 of the third transistor T3, the second electrode 03 of the seventh transistor T7, the first electrode 01 of the fourth transistor T4, and the second electrode 03 of the eighth transistor T8. The area occupied by the memory 300 can be smaller, so that the storage density of the memory 300 can be improved.

It may be understood that, in the orthographic projection toward the reference plane S, the first bit line BL overlaps the first electrode 01 of the first gating transistor T9, the supply voltage line V_{DD} overlaps the second electrode 03 of the fifth transistor T5, the gate 02 of the first gating transistor T9 overlaps the first electrode 01 of the fifth transistor T5, the second electrode 03 of the first gating transistor T9 overlaps the gate 02 of the fifth transistor T5, and to avoid short-circuiting of the first bit line BL and the supply voltage line V_{DD}, an orthographic projection of the first bit line BL on the reference plane S is staggered with an orthographic projection of the supply voltage line V_{DD} on the reference plane S. Similarly, an orthographic projection of the second bit line BL' on the reference plane S should also be staggered with the orthographic projection of the supply voltage line V_{DD} on the reference plane S.

In some embodiments, as shown in FIG. 10, in the first direction X, the supply voltage lines V_{DD} and the ground lines GND may be alternately arranged.

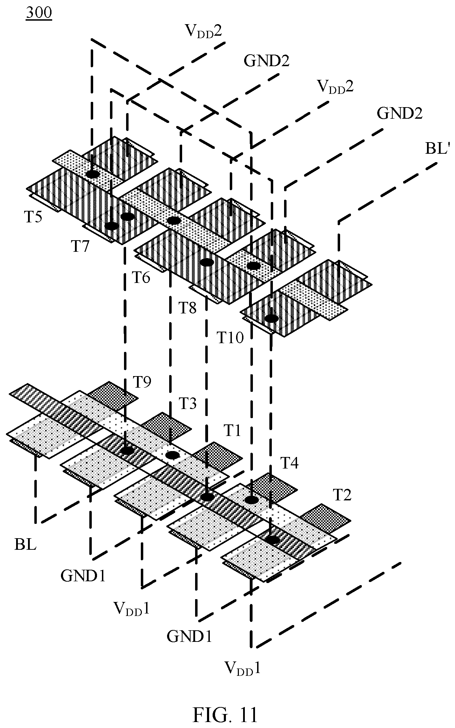

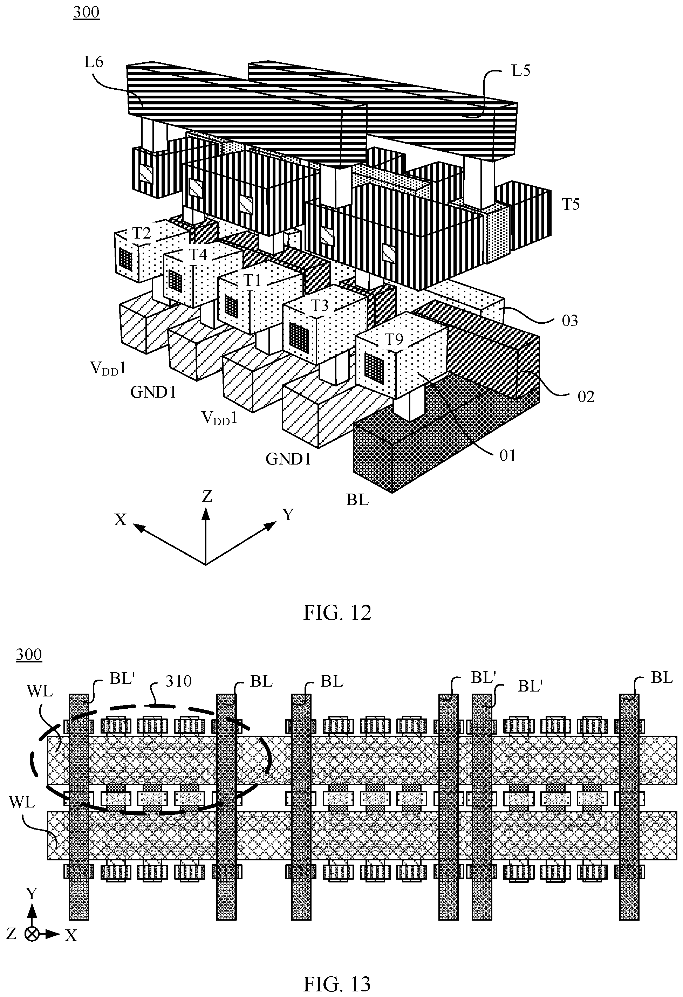

In some other embodiments, as shown in FIG. 11 and FIG. 12, the memory 300 includes the plurality of supply voltage lines V_{DD} and the plurality of ground lines GND. The plurality of supply voltage lines V_{DD} may include a plurality of first supply voltage lines V_{DD1} and a plurality of second supply voltage lines V_{DD}2. The plurality of ground lines GND may include a plurality of first ground lines GND1 and a plurality of second ground lines GND2.

It may be understood that voltages of the plurality of first supply voltage lines V_{DD1} and the plurality of second supply voltage lines V_{DD}2 are the same, and voltages of the plurality of first ground lines GND1 and the plurality of second ground lines GND2 are the same.

In this case, the first bit line BL, the plurality of first supply voltage lines V_{DD}1, and the plurality of first ground lines GND1 may be located on a side that is of the first circuit structure layer 10 and that is away from the second circuit structure layer 20, and all extend in the second direction Y. The second bit line BL', the plurality of second supply voltage lines V_{DD}2, and the plurality of second ground lines GND2 are located on the side that is of the second circuit structure layer 20 and that is away from the first circuit structure layer 10, and all extend in the second direction Y.

The first bit line BL is electrically connected to the first electrode 01 of the first gating transistor T9. The plurality of first supply voltage lines V_{DD}1 are electrically connected to the first electrode 01 of the first transistor T1 and the first electrode 01 of the second transistor T2. The plurality of first ground lines GND1 are electrically connected to the first electrode 01 of the third transistor T3 and the first electrode 01 of the fourth transistor T4.

The second bit line BL' is electrically connected to the second electrode 03 of the second gating transistor T10. The plurality of second supply voltage lines V_{DD}2 are electrically connected to the second electrode 03 of the fifth transistor T5 and the second electrode 03 of the sixth transistor T6. The plurality of second ground lines GND2 are electrically connected to the second electrode 03 of the seventh transistor T7 and the second electrode 03 of the eighth transistor T8.

In the orthographic projection toward the reference plane S, the first bit line BL overlaps the first electrode 01 of the first gating transistor T9, the plurality of first supply voltage lines V_{DD}1 overlap the first electrode 01 of the first transistor T1 and the first electrode 01 of the second transistor T2, and the plurality of first ground lines GND1 overlap the first electrode 01 of the third transistor T3 and the first electrode 01 of the fourth transistor T4.

In the orthographic projection toward the reference plane S, the second bit line BL' overlaps the second electrode 03 of the second gating transistor T10, the plurality of second supply voltage lines V_{DD}2 overlaps the second electrode 03 of the fifth transistor T5 and the second electrode 03 of the sixth transistor T6, and the plurality of second ground lines GND2 overlaps the second electrode 03 of the seventh transistor T7 and the second electrode 03 of the eighth transistor T8.

In this way, the first electrode 01 of the first gating transistor T9, the first electrode 01 of the first transistor T 1, the first electrode 01 of the second transistor T2, the first electrode 01 of the third transistor T3, and the first electrode 01 of the fourth transistor T4 do not need to pass through the dielectric layer and the second circuit structure layer to be connected to a line located on the side that is of the second circuit structure layer and that is away from the first circuit structure layer. Therefore, no transfer layer needs to be formed on the dielectric layer and in the second circuit structure layer, the area occupied by the memory 300 is effectively reduced, and the integration density of the memory 300 is improved.

For example, a technology of buried power rails (buried power rails, BPRs) may be used to dispose the first bit line BL, the plurality of first supply voltage lines V_{DD}1, and the plurality of first ground lines GND1 on the side that is of the first circuit structure layer 10 and that is away from the second circuit structure layer 20.

In some embodiments, in the first direction X, the plurality of first supply voltage lines V_{DD}1 and the plurality of first ground lines GND1 may be alternately arranged, and the plurality of second supply voltage lines V_{DD}2 and the plurality of second ground lines GND2 may be alternately arranged.

FIG. 13 is a top view of a part of the memory 300 according to an embodiment of this application. As shown in FIG. 13, the memory 300 includes the plurality of memory cells 310. The plurality of memory cells 310 are arranged in an array. For example, the plurality of memory cells 310 may be arranged in a plurality of rows in the first direction X, and may be arranged in a plurality of columns in the second direction Y.

Memory cells 310 in a same row may be connected to a same word line WL, and memory cells 310 in a same column may be connected to a same pair of first bit lines BL and second bit lines BL'.

In some embodiments, two adjacent memory cells 310 in the first direction X may be mirror-symmetric. To be specific, in the first direction X, first gating transistors T9 of the two adjacent memory cells 310 are adjacently disposed, and fifth transistors of the two adjacent memory cells 310 are adjacently disposed. Alternatively, in the first direction X, second gating transistors T10 of the two adjacent memory cells 310 are adjacently disposed, and second transistors T2 of the two adjacent memory cells 310 are adjacently disposed.

In some embodiments, two adjacent memory cells 310 in the second direction Y may be mirror-symmetric. To be specific, in a same circuit structure layer (the first circuit structure layer or the second circuit structure layer), first electrodes or second electrodes of the two adjacent transistors in the second direction Y are adjacent to each other.

In the first circuit structure layer 10, the first electrodes of the plurality of transistors are configured to connect to a signal line (for example, the supply voltage line, the ground line, or a bit line). In this case, when the two adjacent memory cells 310 in the second direction Y are mirror-symmetric, in the first circuit layer, and when first electrodes of two transistors that are respectively located in the two adjacent memory cells 310 are adjacent to each other, the first electrodes of the two transistors may be shared, to be connected to a same signal line.

Similarly, in the second circuit structure layer 20, the second electrodes of the plurality of transistors are also configured to connect to a signal line. In this case, when the two adjacent memory cells 310 in the second direction Y are mirror-symmetric, in the second circuit structure layer 20, and when second electrodes of two transistors that are respectively located in the two adjacent memory cells 310 are adjacent to each other, the second electrodes of the two transistors may be shared, to be connected to a same signal line.

Through such a disposal, the area occupied by the memory 300 can be further reduced, and the integration density of the memory cell 310 in the memory 300 can be further improved.

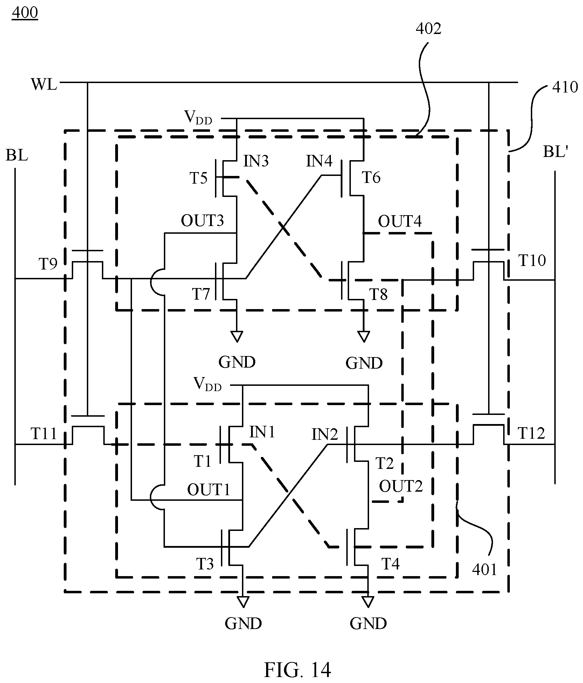

In some embodiments of this application, another memory 400 is provided. The memory 400 includes a plurality of memory cells 410, a first bit line BL, a second bit line BL', supply voltage lines V_{DD}, and ground lines GND. FIG. 14 is a circuit diagram of the memory 400 according to an embodiment of this application. FIG. 14 shows one of the plurality of memory cells 410 of the memory 400.

The memory cell 410 includes a first inverter 401 and a second inverter 402. The first inverter 401 includes a first input port IN1, a second input port IN2, a first output port OUT1, and a second output port OUT2. The second inverter 402 includes a third input port IN3, a fourth input port IN4, a third output port OUT3, and a fourth output port OUT4. A connection relationship between the first inverter 401 and the second inverter 402 is the same as the connection relationship between the first inverter 301 and the second inverter 302 in the foregoing embodiment, and is not described herein again. The first inverter 401 and the second inverter 402 are cascaded to form a latch.

In some examples, the first inverter 401 may include a first transistor T1, a second transistor T2, a third transistor T3, and a fourth transistor T4. The second inverter 402 may include a fifth transistor T5, a sixth transistor T6, a seventh transistor T7, and an eighth transistor T8. The foregoing plurality of transistors each include a first electrode, a gate, and a second electrode. The first electrode is one of a source and a drain, and the second electrode is the other of the source and the drain. First electrodes of different transistors may be all sources or all drains, or may be a source and a drain.

A conductive connection relationship between the first transistor T1, the second transistor T2, the third transistor T3, and the fourth transistor T4 of the first inverter 401 is the same as the conductive connection relationship between the first transistor T1, the second transistor T2, the third transistor T3, and the fourth transistor T4 of the first inverter 301 in the foregoing embodiment. A conductive connection relationship between the fifth transistor T5, the sixth transistor T6, the seventh transistor T7, and the eighth transistor T8 of the second inverter 402 is the same as the conductive connection relationship of the fifth transistor T5, the sixth transistor T6, the seventh transistor T7, and the eighth transistor T8 of the second inverter 302 in the foregoing embodiment. Details are not described herein again in this embodiment of this application.

Compared with that in the memory cell 310 provided in the foregoing embodiment, two gating transistors are added to the memory cell 410 provided in this embodiment of this application. As shown in FIG. 14, the memory cell 410 may further include a first gating transistor T9, a second gating transistor T10, a third gating transistor T11, and a fourth gating transistor T12. The first gating transistor T9 and the third gating transistor T11 are configured to control a connection between the latch and the first bit line BL. The second gating transistor T10 and the fourth gating transistor T12 are configured to control a connection between the latch and the second bit line BL'. The first gating transistor T9, the second gating transistor T10, the third gating transistor T11, and the fourth gating transistor T12 are controlled by a word line WL, and are conducted or cut off at the same time.

The first gating transistor T9, the second gating transistor T10, the third gating transistor T11, and the fourth gating transistor T12 each include a first electrode, a gate, and a second electrode. The first electrode is one of a source and a drain, and the second electrode is the other of the source and the drain.

For example, the first electrode of the first gating transistor T9 is electrically connected to the first bit line BL, and the second electrode of the first gating transistor T9 is electrically connected to the first output port OUT1 of the first inverter 401 and the fourth input port IN4 of the second inverter 302. To be specific, the second electrode of the first gating transistor T9 is electrically connected to the gate of the sixth transistor T6, the gate of the seventh transistor T7, the second electrode of the first transistor T1, and the second electrode of the third transistor T3.

The first electrode of the second gating transistor T10 is electrically connected to the second bit line BL', and the second electrode of the second gating transistor T10 is electrically connected to the third input port IN3 of the second inverter 402 and the second output port OUT2 of the first inverter. To be specific, the second electrode of the second gating transistor T10 is electrically connected to the gate of the fifth transistor T5, the gate of the eighth transistor T8, the second electrode of the second transistor T2, and the second electrode of the fourth transistor T4.

The second electrode of the third gating transistor T11 is electrically connected to the first bit line BL, and the first electrode of the third gating transistor T11 is electrically connected to the first input port IN1 of the first inverter 401 and the fourth output port OUT4 of the second inverter 402. To be specific, the first electrode of the third gating transistor T11 is electrically connected to the gate of the first transistor T1, the gate of the fourth transistor T4, the first electrode of the sixth transistor T6, and the first electrode of the eighth transistor T8.

The second electrode of the fourth gating transistor T12 is electrically connected to the second bit line BL', and the first electrode of the fourth gating transistor T12 is electrically connected to the second input port IN2 of the first inverter 401 and the third output port OUT3 of the second inverter 402. To be specific, the first electrode of the fourth gating transistor T12 is electrically connected to the gate of the second transistor T2, the gate of the third transistor T3, the first electrode of the fifth transistor T5, and the first electrode of the seventh transistor T7.

The two gating transistors are added to the memory cell 410 provided in this embodiment of this application, so that stability and a read/write speed of the memory cell 410 can be improved, and it is ensured that an input/output port of the memory cell 410 can be stably reversed.

A plurality of transistors of the plurality of memory cells 410 provided in the foregoing embodiment of this application have a same polarity. In FIG. 14, for example, the plurality of transistors are all N-type transistors. In some other examples, the plurality of transistors in the memory cell 410 may be all P-type transistors.

The following briefly describes a working procedure of the memory cell 410 with reference to the circuit diagram provided in FIG. 14.

Same as that in the foregoing embodiment, the working procedure of the memory cell 310 includes a write procedure and a read procedure. In a write phase, the word line WL receives a high-level signal, and the first gating transistor T9, the second gating transistor T10, the third gating transistor T11, and the fourth gating transistor T12 are all conducted. When a high level is written, the first bit line BL receives the high-level signal, and the second bit line BL' receives a low-level signal. If a voltage of the second electrode of the first gating transistor T9 and a voltage of the second electrode of the second gating transistor T10 are high levels, and a voltage of the first electrode of the third gating transistor T11 and a voltage of the first electrode of the fourth gating transistor T12 are low levels, the voltages of the second electrode of the first gating transistor T9, the second electrode of the second gating transistor T10, the first electrode of the third gating transistor T11, and the first electrode of the fourth gating transistor T12 remain unchanged. On the contrary, if the voltage of the second electrode of the first gating transistor T9 and the voltage of the second electrode of the second gating transistor T10 are low levels, and the voltage of the first electrode of the third gating transistor T11 and the voltage of the first electrode of the fourth gating transistor T12 are high levels, the voltages of the second electrode of the first gating transistor T9, the second electrode of the second gating transistor T10, the first electrode of the third gating transistor T11, and the first electrode of the fourth gating transistor T12 are reversed. Then, the word line WL receives a low-level signal, and the first gating transistor T9, the second gating transistor T10, the third gating transistor T11, and the fourth gating transistor T12 are all cut off. A write procedure of a low level is similar to the foregoing write procedure of the high level. Details are not described herein again.

In the read procedure, the word line WL receives a low-level signal, and the first gating transistor T9, the second gating transistor T10, the third gating transistor T11, and the fourth gating transistor T12 are all cut off. After the first bit line BL and the second bit line BL' are pre-charged to a same voltage (for example, pre-charged to the high level), the word line WL receives a high-level signal, the first gating transistor T9, the second gating transistor T10, the third gating transistor T11, and the fourth gating transistor T12 are all conducted. When the latch stores the high level, a level of the first bit line BL is the same as a level of the second electrode of the first gating transistor T9 and a level of the second electrode of the second gating transistor T10, and a level of the second bit line BL' is different from a level of the first electrode of the third gating transistor T11 and a level of the first electrode of the fourth gating transistor T12. The second bit line BL' is discharged, and a voltage decreases. A voltage difference is generated between the first bit line BL and the second bit line BL', and the voltage difference is read to complete a read operation.

After a write operation is completed, the memory cell enters a static signal holding phase. In the static signal holding phase, in any one of parallel paths of the latch, only one transistor is conducted, and the other transistor is cut off. For example, when the transistors in the latch are NMOSFETs, after the high level is written, the first transistor T1, the fourth transistor T4, the sixth transistor T6, and the seventh transistor T7 are all conducted, and the second transistor T2, the third transistor T3, the fifth transistor T5, and the eighth transistor T8 are all cut off.

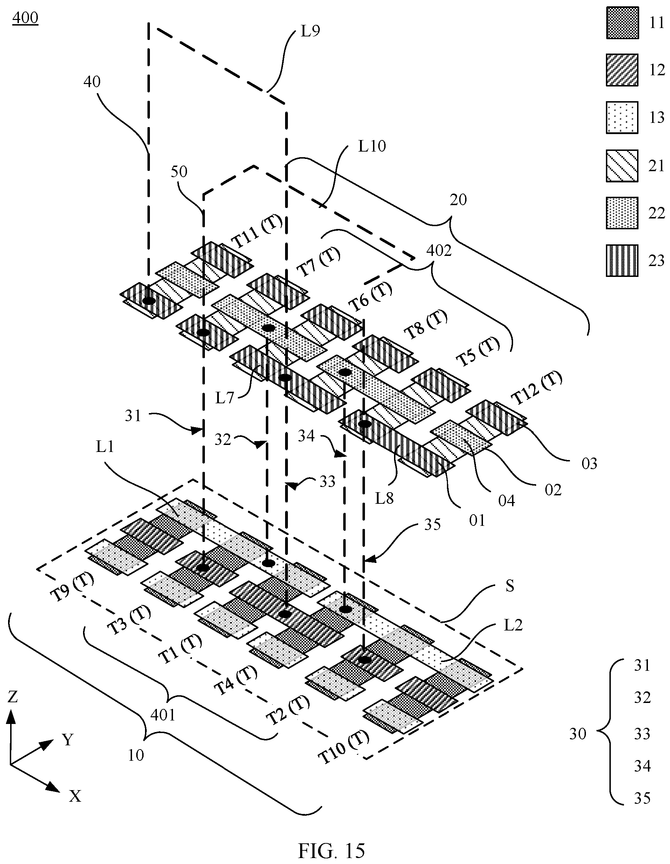

FIG. 15 is a diagram of a structure of the memory 400 according to an embodiment of this application. With reference to FIG. 15, same as that in the foregoing embodiment, the memory 400 includes a first circuit structure layer 10, a second circuit structure layer 20, and a plurality of interconnection structures 30. The first circuit structure layer 10 includes the first inverter 401. The second circuit structure layer 20 is stacked with the first circuit structure layer 10, and the second circuit structure layer 20 includes the second inverter 402. The interconnection structure 30 is located between the first circuit structure layer 10 and the second circuit structure layer 20.

The first inverter 401 and the second inverter 402 each include a plurality of transistors T. The plurality of transistors T of the first inverter 401 and the plurality of transistors T of the second inverter 402 have a same polarity. The plurality of transistors T of the first inverter 401 and the plurality of transistors T of the second inverter 402 are all sequentially arranged in a first direction X parallel to a reference plane S. The reference plane S is a plane on which the lower surface of the first circuit structure layer 10 is located. Orthographic projections of the plurality of transistors T of the first inverter 401 on the reference plane S overlap orthographic projections of the plurality of transistors T of the second inverter 402 on the reference plane S. The first inverter 401 is electrically connected to the second inverter 402 through the plurality of interconnection structures 30.

Technical effect that can be achieved by the memory 400 provided in this embodiment of this application is the same as technical effect that can be achieved by the memory 300 provided in the foregoing embodiment. Details are not described herein again.

As shown in FIG. 15, in some embodiments, the transistor T includes a first electrode 01, a gate 02, and a second electrode 03 that are sequentially arranged in a second direction Y. The second direction Y is parallel to the reference plane S and perpendicular to the first direction X. In an orthographic projection toward the reference plane S, the gate 02 of the transistor T of the first inverter 401 overlaps the first electrode 01 of the transistor T of the second inverter 402, and the second electrode 03 of the transistor T of the first inverter 401 overlaps the gate 02 of the transistor T of the second inverter 402.

In this way, an overlapping area between the transistor of the first inverter 401 and the transistor of the second inverter 402 is large, and an area occupied by the memory cell is small. In addition, the gate 02 of the transistor T of the first inverter 401 overlaps the first electrode 01 of the transistor T of the second inverter 402, and the second electrode 03 of the transistor T of the first inverter 401 overlaps the gate 02 of the transistor T of the second inverter 402. This further helps make the interconnection structure 30 perpendicular to the first circuit structure layer 10 and the second circuit structure layer 20, and simplifies the plurality of interconnection structures, so that an orthographic projection of the interconnection structure 30 on the reference plane S is small, and an area occupied by the interconnection structure 30 is small.

Similar to that in the foregoing embodiment, the first circuit structure layer 10 may include a first active layer 11, a first gate layer 12, a first source and drain electrode layer 13, and a plurality of dielectric layers (not shown) that are stacked.

The plurality of dielectric layers may include a dielectric layer located on a side that is of the first active layer 11 and that is away from the first gate layer 12, a dielectric layer that insulates the first active layer 11 from the first gate layer 12, a dielectric layer that insulates the first source and drain electrode layer 13 from the first gate layer 12, and the like.

Gates 02 of the plurality of transistors T of the first inverter 401 may be located in the first gate layer 12, and first electrodes 01 and second electrodes 03 of the plurality of transistors T of the first inverter 401 may be located in the first source and drain electrode layer 13. The plurality of transistors T of the first inverter 401 may further include channels 04. The channels 04 may be formed in the first active layer 11, and are in a same transistor T. An orthographic projection of the channel 04 on the reference plane S partially overlaps an orthographic projection of the gate 02 on the reference plane S. The first electrode 01 and the second electrode 03 of the transistor T may pass through the dielectric layer to be electrically in contact with the channel 04.

In some embodiments, the second circuit structure layer 20 may include a second active layer 21, a second gate layer 22, a second source and drain electrode layer 23, and a plurality of dielectric layers (not shown) that are stacked.

The plurality of dielectric layers may include a dielectric layer located on a side that is of the second active layer 21 and that is away from the second gate layer 22, a dielectric layer that insulates the second active layer 21 from the second gate layer 22, and a dielectric layer that insulates the second source and drain electrode layer 23 from the second gate layer 22.

Gates 02 of the plurality of transistors T of the second inverter 402 may be located in the second gate layer 22, and first electrodes 01 and second electrodes 03 of the plurality of transistors T of the second inverter 402 may be located in the second source and drain electrode layer 23. The plurality of transistors T of the second inverter 402 may further include channels 04. The channels 04 may be formed in the second active layer 21, and are in a same transistor T. An orthographic projection of the channel 04 on the reference plane S overlaps an orthographic projection of the gate 02 on the reference plane S. The first electrode 01 and the second electrode 03 of the transistor T may pass through the dielectric layer to be in contact with the channel 04.

Still with reference to FIG. 15, in some embodiments, a dielectric layer may also exist between the first circuit structure layer 10 and the second circuit structure layer 20. The plurality of interconnection structures 30 may pass through the dielectric layer (not shown) to connect the first inverter 401 in the first circuit structure layer 10 to the second inverter 402 in the second circuit structure layer 20.

It may be understood that FIG. 15 shows merely a possible structure of the memory 400 in this embodiment of this application, and the structures of the plurality of transistors T in the memory 400 are not limited thereto.

Still with reference to FIG. 15, in some embodiments, in the orthographic projection toward the reference plane S, the first electrode 01 of the transistor T of the first inverter 401 is staggered with the second electrode 03 of the transistor T of the second inverter 402. Through such a disposal, it can be convenient to connect a plurality of transistors T of the first inverter 401 and the second inverter 402 to other lines (for example, a supply voltage line, a ground line, and a bit line).

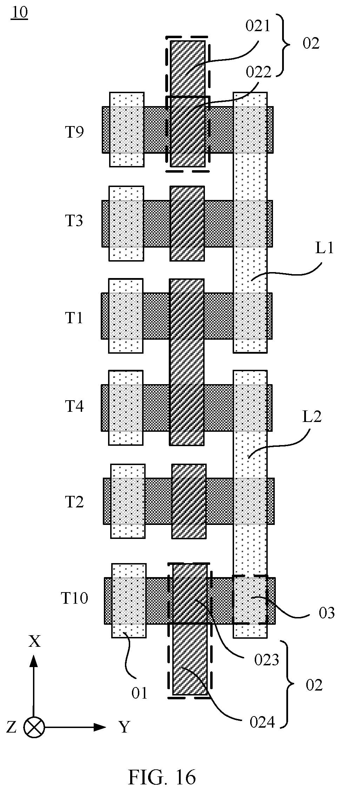

As shown in FIG. 16, the first inverter 401 includes the first transistor T1, the second transistor T2, the third transistor T3, and the fourth transistor T4. In the first direction X, the third transistor T3, the first transistor T1, the fourth transistor T4, and the second transistor T2 are sequentially arranged. The first transistor T1 and the fourth transistor T4 share the gate. The first circuit structure layer 10 further includes a first connection line L1 and a second connection line L2. A second electrode 03 of the third transistor T3 is electrically connected to a second electrode 03 of the first transistor T1 through the first connection line L1. A second electrode 03 of the fourth transistor T4 is electrically connected to a second electrode 03 of the second transistor T2 through the second connection line L2.

In some examples, the first connection line L1 and the second connection line L2 may extend in the first direction X. In this way, the first connection line L1 and the second connection line L2 have simple shapes and are easy to prepare, and areas occupied by the first connection line L1 and the second connection line L2 can be small.

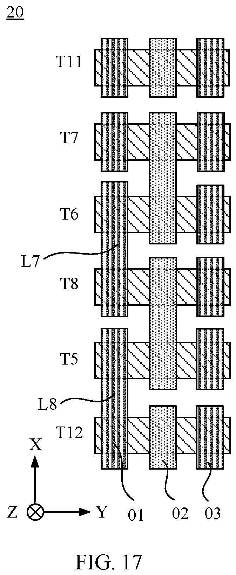

As shown in FIG. 17, the second inverter 402 includes the fifth transistor T5, the sixth transistor T6, the seventh transistor T7, and the eighth transistor T8. In the first direction X, the seventh transistor T7, the sixth transistor T6, the eighth transistor T8, and the fifth transistor T5 are sequentially arranged. The fifth transistor T5 and the eighth transistor T8 share the gate, and the sixth transistor T6 and the seventh transistor T7 share the gate. The second circuit structure layer 20 further includes a seventh connection line L7. A first electrode 01 of the sixth transistor T6 is electrically connected to a first electrode 01 of the eighth transistor T8 through the seventh connection line L7.

In some examples, the seventh connection line L7 may extend in the first direction X. In this way, the seventh connection line L7 has a simple shape and is easy to prepare, and an area occupied by the seventh connection line L7 can be small.

Based on the distributed structure of the first inverter 401 and the second inverter 402, to implement the circuit connection relationship provided in FIG. 14, the plurality of interconnection structures 30 include a first interconnection structure 31, a second interconnection structure 32, a third interconnection structure 33, a fourth interconnection structure 34, and a fifth interconnection structure 35.

A gate 02 of the third transistor T3 is electrically connected to a first electrode 01 of the seventh transistor T7 through the first interconnection structure 31. A gate 02 of the seventh transistor T7 is electrically connected to the first connection line L1 through the second interconnection structure 32. A gate 02 of the first transistor T1 is electrically connected to the seventh connection line L7 through the third interconnection structure 33. The second connection line L2 is electrically connected to a gate 02 of the eighth transistor T8 through the fourth interconnection structure 34. A gate 02 of the second transistor T2 is electrically connected to a first electrode 01 of the fifth transistor T5 through the fifth interconnection structure 35.

As shown in FIG. 15, the first interconnection structure 31, the second interconnection structure 32, the third interconnection structure 33, the fourth interconnection structure 34, and the fifth interconnection structure 35 may be perpendicular to the first circuit structure layer 10 and the second circuit structure layer 20. In this way, structures of the plurality of interconnection structures are simple, so that an orthographic projection of the interconnection structure 30 on the reference plane S is small, and an area occupied by the interconnection structure 30 is small.

In some embodiments, as shown in FIG. 16 and FIG. 17, the first circuit structure layer 10 further includes the first gating transistor T9 and the second gating transistor T10. In the first direction X, the first gating transistor T9 is located on a side that is of the third transistor T3 and that is away from the first transistor T1, and the second gating transistor T10 is located on a side that is of the second transistor T2 and that is away from the fourth transistor T4.

The second circuit structure layer 20 further includes the third gating transistor T11 and the fourth gating transistor T12. In the first direction X, the third gating transistor T11 is located on a side that is of the seventh transistor T7 and that is away from the sixth transistor T6, and the fourth gating transistor T12 is located on a side that is of the fifth transistor T5 and that is away from the eighth transistor T8.

The first gating transistor T9, the second gating transistor T10, the third gating transistor T11, and the fourth gating transistor T12 include first electrodes 01, gates 02, and second electrodes 03 that are sequentially arranged in the second direction Y. The second electrode 03 of the first gating transistor T9 is electrically connected to the first connection line L. The second electrode 03 of the second gating transistor T10 is electrically connected to the second connection line L2. The second circuit structure layer 20 further includes an eighth connection line L8. The first electrode 01 of the fifth transistor T5 is electrically connected to a first electrode 01 of the fourth gating transistor T12 through the eighth connection line L8.

In this embodiment of this application, the second electrode 03 of the first transistor T1, the second electrode 03 of the third transistor T3, and the second electrode 03 of the first gating transistor T9 are electrically connected through the first connection line L1. The second electrode 03 of the second transistor T2, the second electrode 03 of the fourth transistor T4, and the second electrode 03 of the second gating transistor T10 are electrically connected through the second connection line L2. In this way, the area occupied by the memory cell 410 can be small, and area utilization of the memory 400 is improved.

In some examples, the eighth connection line L8 may extend in the first direction X. In this way, the eighth connection line L8 has a simple shape and is easy to prepare, and an area occupied by the eighth connection line L8 can be small.

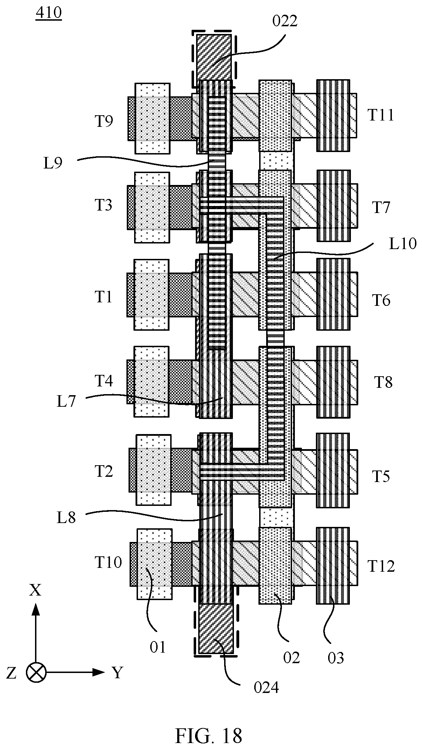

With reference to FIG. 15 and FIG. 18, the memory 400 further includes a ninth connection line L9 and a tenth connection line L10, located on a side that is of the second circuit structure layer 20 and that is away from the first circuit structure layer 10. The ninth connection line L9 is electrically connected to a first electrode 01 of the third gating transistor T11 and the seventh connection line L7. The tenth connection line L10 is electrically connected to the first electrode 01 of the seventh transistor T7 and the eighth connection line L8.

In some embodiments, the memory 400 may further include two first connection parts 40 and two second connection parts 50. One end of the ninth connection line L9 is electrically connected to the first electrode 01 of the third gating transistor T11 through one first connection part 40, and the other end of the ninth connection line L9 is electrically connected to the seventh connection line L7 through the other first connection part 40. One end of the tenth connection line L10 is electrically connected to the first electrode 01 of the seventh transistor T7 through one second connection part 50, and the other end of the tenth connection line L10 is electrically connected to the eighth connection line L8 through the other second connection part 50. The two first connection parts 40 and the two second connection parts 50 are alternately arranged in the first direction X.

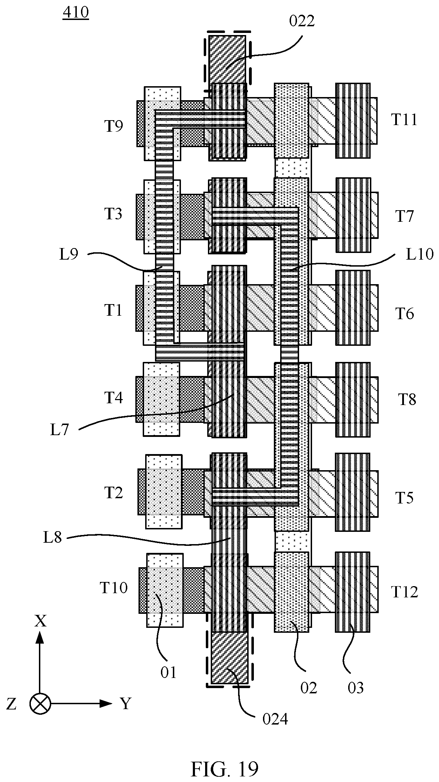

In some examples, as shown in FIG. 19, the ninth connection line L9 and the tenth connection line L10 may be at a same layer. The ninth connection line L9 avoids the second connection part 50, and the tenth connection line L10 avoids the first connection part 40.

In this case, structures of the ninth connection line L9 and the tenth connection line L10 are not limited in embodiment of this application provided that the ninth connection line L9 can avoid the second connection part 50 and the tenth connection line L10 can avoid the first connection part 40. In FIG. 19, for example, the ninth connection line L9 and the tenth connection line L10 each are in a broken line shape.

In this embodiment of this application, the ninth connection line L9 and the tenth connection line L10 are at the same layer. In this way, the ninth connection line L9 and the tenth connection line L10 can be prepared at the same time. This simplifies a preparation process of the memory cell 410, and reduces preparation costs of the memory cell 410.

In some other examples, as shown in FIG. 15 and FIG. 18, the ninth connection line L9 is located on a side that is of the tenth connection line L10 and that is away from the second circuit structure layer 20, and the tenth connection line L10 is in the broken line shape. In the orthographic projection toward the reference plane S, the tenth connection line L10 avoids the first connection part 40.

In this case, the ninth connection line L9 may be in a straight line shape, and extend in the first direction X. In this way, the ninth connection line L9 has a simple structure and a small occupation area. This helps reduce the area occupied by the memory cell 410, and improve integration density of the memory 400.

In some embodiments, as shown in FIG. 16, the gate 02 of the first gating transistor T9 includes a first part 021 and a second part 022. The second part 022 is away from the third transistor T3 relative to the first part 021. In the orthographic projection toward the reference plane S, the first part 021 overlaps the first electrode 01 of the third gating transistor T11, and the second part 022 does not overlap the first electrode 01 of the third gating transistor T11.

The gate 02 of the second gating transistor T10 includes a third part 023 and a fourth part 024. The fourth part 024 is away from the second transistor T2 relative to the third part 023. In the orthographic projection toward the reference plane S, the third part 023 overlaps the first electrode 01 of the fourth gating transistor T12, and the fourth part 024 does not overlap the first electrode 01 of the fourth gating transistor T12.

In this way, the second part 022 may not be blocked by the first electrode of the third gating transistor T11, and the fourth part 024 may not be blocked by the first electrode 01 of the fourth gating transistor T12. Therefore, a connection between the gate 02 of the first gating transistor T9 and the word line WL is easily implemented, and a connection between the gate 02 of the second gating transistor T10 and the word line WL is easily implemented.

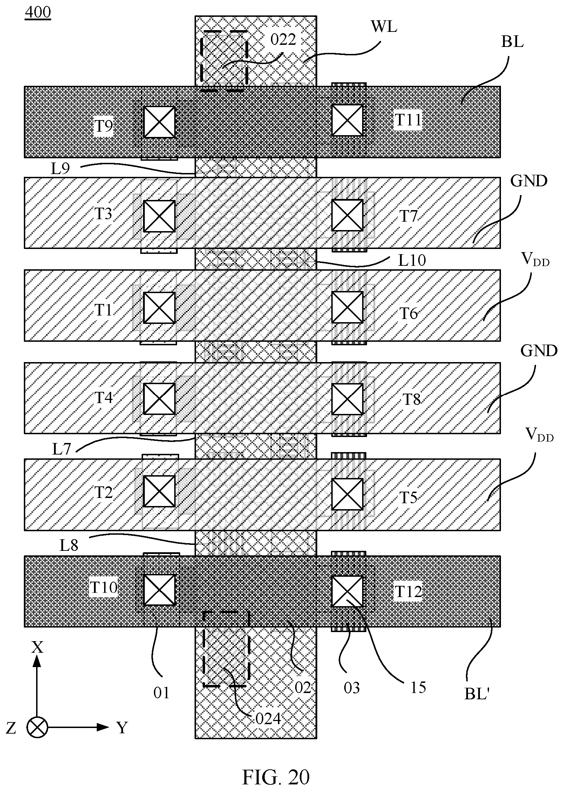

In some embodiments, as shown in FIG. 20, the memory 400 further includes the word line WL. The word line WL is located on the side that is of the second circuit structure layer 20 and that is away from the first circuit structure layer 10, and extends in the first direction X. The word line WL is electrically connected to the gate 02 of the first gating transistor T9, the gate 02 of the second gating transistor T10, the gate 02 of the third gating transistor T11, and the gate 02 of the fourth gating transistor T12. In the orthographic projection toward the reference plane S, the word line WL overlaps the second part 022, the fourth part 024, the gate 02 of the third gating transistor T11, and the gate 02 of the fourth gating transistor T12.

It may be understood that, to insulate the word line WL from a component in the second circuit structure 20, a dielectric layer (not shown) may be disposed between the word line WL and the second circuit structure layer 20.

In this embodiment of this application, the word line WL extends in the first direction X, so that the word line WL has a simple shape and is easy to prepare, and an area occupied by the word line WL is reduced. In addition, the word line WL overlaps the second part 022, the fourth part 024, the gate 02 of the third gating transistor T11, and the gate 02 of the fourth gating transistor T12, so that the word line WL can further pass through a via in the dielectric layer to be electrically connected to the second part 022, the fourth part 024, the gate 02 of the third gating transistor T11, and the gate 02 of the fourth gating transistor T12. This simplifies the structure of the memory 400, reduces the area occupied by the memory 400, and improves storage density and the area utilization of the memory 400.

Still with reference to FIG. 20, in some embodiments, the memory 400 further includes the first bit line BL and the second bit line BL'. The first bit line BL and the second bit line BL' are located on the side that is of the second circuit structure layer 20 and that is away from the first circuit structure layer 10, and extend in the second direction Y.

The first bit line BL is electrically connected to the first electrode 01 of the first gating transistor T9 and the second electrode 03 of the third gating transistor T11. The second bit line BL' is electrically connected to the first electrode 01 of the second gating transistor T10 and the second electrode 03 of the fourth gating transistor T12. In the orthographic projection toward the reference plane S, the first bit line BL overlaps the first electrode 01 of the first gating transistor T9 and the second electrode 03 of the third gating transistor T11, and the second bit line BL' overlaps the first electrode 01 of the second gating transistor T10 and the second electrode 03 of the fourth gating transistor T12.

It may be understood that, to insulate the first bit line BL and the second bit line BL' from the component in the second circuit structure layer 20, a dielectric layer (not shown) may be disposed between the first bit line BL and the second bit line BL', and the second circuit structure layer 20.

In some examples, the first bit line BL and the second bit line BL' may be located at a same layer. In this case, materials of the first bit line BL and the second bit line BL' may be the same. In this way, the first bit line BL and the second bit line BL' can be prepared at the same time. This simplifies a preparation process of the memory 400, and reduces preparation costs of the memory 400.

In this embodiment of this application, in the orthographic projection toward the reference plane S, the first bit line BL overlaps the first electrode 01 of the first gating transistor T9 and the second electrode 03 of the third gating transistor T11, and the second bit line BL' overlaps the first electrode 01 of the second gating transistor T10 and the second electrode 03 of the fourth gating transistor T12. In this way, the first bit line BL can pass through a via 15 in the dielectric layer to be electrically connected to the first electrode 01 of the first gating transistor T9 and the second electrode 03 of the third gating transistor T11, and the second bit line BL' can pass through a via 15 in the dielectric layer to be electrically connected to the first electrode 01 of the second gating transistor T10 and the second electrode 03 of the fourth gating transistor T12. The area occupied by the memory 400 can be smaller, so that the storage density and the area utilization of the memory 400 can be improved.

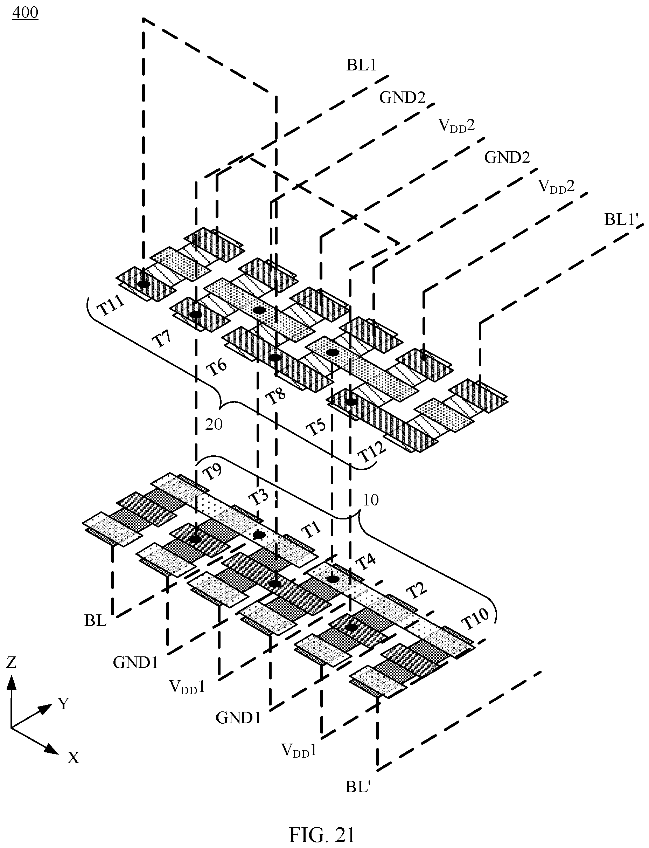

In some other embodiments, as shown in FIG. 21, the memory 400 may include a plurality of supply voltage lines V_{DD} and a plurality of ground lines GND. The plurality of supply voltage lines V_{DD} may include a plurality of first supply voltage lines V_{DD}1 and a plurality of second supply voltage lines V_{DD}2. The plurality of ground lines GND may include a plurality of first ground lines GND1 and a plurality of second ground lines GND2.

It may be understood that voltages of the plurality of first supply voltage lines V_{DD}1 and the plurality of second supply voltage lines V_{DD}2 are the same, and voltages of the plurality of first ground lines GND1 and the plurality of second ground lines GND2 are the same.

The memory 400 may include the first bit line BL, the second bit line BL', a third bit line BL1, and a fourth bit line BL1'. A signal on the third bit line BL1 is the same as a signal on the first bit line BL. A signal on the fourth bit line BL1' is the same as a signal on the second bit line BL'.

It may be understood that, because the signal on the third bit line BL1 is the same as the signal on the first bit line BL, the transistor is connected to the third bit line BL1, and may be equivalently electrically connected to the first bit line BL in the circuit diagram. Because the signal on the fourth bit line BL1' is the same as the signal on the second bit line BL', the transistor is electrically connected to the fourth bit line BL1', and may be equivalently electrically connected to the second bit line BL' in the circuit diagram.

For example, the first bit line BL, the second bit line BL', the plurality of first supply voltage lines V_{DD}1, and the plurality of first ground lines GND1 are located on a side that is of the first circuit structure layer 10 and that is away from the second circuit structure layer 20, and all extend in the second direction Y. The third bit line BL1, the fourth bit line BL1', the plurality of second supply voltage lines V_{DD}2, and the plurality of second ground lines GND2 are located on the side that is of the second circuit structure layer 20 and that is away from the first circuit structure layer 10, and all extend in the second direction Y.

The first bit line BL is electrically connected to the first electrode 01 of the first gating transistor T9. The second bit line BL' is electrically connected to the first electrode 01 of the second gating transistor T10. The plurality of first supply voltage lines V_{DD}1 are electrically connected to a first electrode 01 of the first transistor T1 and a first electrode 01 of the second transistor T2. The plurality of first ground lines GND1 are electrically connected to a first electrode 01 of the third transistor T3 and a first electrode 01 of the fourth transistor T4.

In the orthographic projection toward the reference plane S, the first bit line BL overlaps the first electrode 01 of the first gating transistor T9, the second bit line BL' overlaps the first electrode 01 of the second gating transistor T10, the plurality of first supply voltage lines V_{DD}1 overlap the first electrode 01 of the first transistor T1 and the first electrode 01 of the second transistor T2, and the plurality of first ground lines GND1 overlap the first electrode 01 of the third transistor T3 and the first electrode 01 of the fourth transistor T4.

The third bit line BL1 is electrically connected to the second electrode 03 of the third gating transistor T11. The fourth bit line BL1' is electrically connected to the second electrode 03 of the fourth gating transistor T12. The plurality of second supply voltage lines V_{DD}2 are electrically connected to a second electrode 03 of the fifth transistor T5 and a second electrode 03 of the sixth transistor T6. The plurality of second ground lines GND2 are electrically connected to a second electrode 03 of the seventh transistor T7 and a second electrode 03 of the eighth transistor T8.

In the orthographic projection toward the reference plane S, the third bit line BL1 overlaps the second electrode 03 of the third gating transistor T11, the fourth bit line BL1' overlaps the second electrode 03 of the fourth gating transistor T12, the plurality of second supply voltage lines V_{DD}2 overlap the second electrode 03 of the fifth transistor T5 and the second electrode 03 of the sixth transistor T6, and the plurality of second ground lines GND2 overlap the second electrode 03 of the seventh transistor T7 and the second electrode 03 of the eighth transistor T8.

In this way, the first electrode 01 of the first gating transistor T9, the first electrode 01 of the second gating transistor T10, the first electrode 01 of the first transistor T1, the first electrode 01 of the second transistor T2, the first electrode 01 of the third transistor T3, and the first electrode 01 of the fourth transistor T4 do not need to pass through the dielectric layer and the second circuit structure layer to be connected to the third bit line BL1, the fourth bit line BL1', the plurality of second supply voltage lines V_{DD}2, and the plurality of second ground lines GND2 that are located on the side that is of the second circuit structure layer and that is away from the first circuit structure layer. Therefore, no transfer layer needs to be formed on the dielectric layer or in the second circuit structure layer, the area occupied by the memory 400 is effectively reduced, and the integration density of the memory 400 is improved.

In some embodiments, the memory 400 may include the plurality of memory cells 410. The plurality of memory cells 410 are arranged in an array. For example, the plurality of memory cells 410 may be arranged in a plurality of rows in the first direction X and in a plurality of columns in the second direction Y. Memory cells 410 in a same row may be connected to a same word line WL, and memory cells 410 in a same column may be connected to a same pair of first bit lines BL and second bit lines BL'.

In some embodiments, two adjacent memory cells 410 in the first direction X may be mirror-symmetric.

In some embodiments, two adjacent memory cells 410 in the second direction Y may be mirror-symmetric.

An arrangement manner of the plurality of memory cells 410 in this embodiment of this application may be similar to the arrangement manner of the plurality of memory cells 310 provided in the foregoing embodiment. Details are not described herein again in this embodiment of this application.

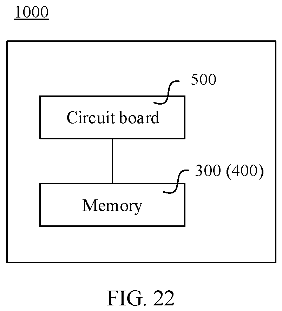

As shown in FIG. 22, some embodiments of this application provide an electronic device 1000. The electronic device 1000 includes a circuit board 500 and the memory (the memory 300 or the memory 400) provided in any one of the foregoing embodiments. The memory 300 or the memory 400 is electrically connected to the circuit board 500.

The electronic device 1000 may be a terminal device, for example, a mobile phone, a tablet computer, or a smart band, or may be a personal computer (personal computer, PC), a server, or a workstation. A specific form of the electronic device 1000 is not specifically limited in embodiments of this application.

Beneficial effect that can be achieved by the electronic device 1000 provided in embodiments of this application is the same as the beneficial effect that can be achieved by the memory 300 or the memory 400 provided in the foregoing embodiment of this application.

In the descriptions of this specification, the described specific features, structures, materials, or characteristics may be combined in an appropriate manner in any one or more of embodiments or examples.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A memory, comprising:
a first circuit structure layer, comprising a first inverter;
a second circuit structure layer, stacked with the first circuit structure layer, and comprising a second inverter; and
a plurality of interconnection structures, located between the first circuit structure layer and the second circuit structure layer, wherein
the first inverter and the second inverter each comprise a plurality of transistors, and the plurality of transistors of the first inverter and the plurality of transistors of the second inverter have a same polarity; the plurality of transistors of the first inverter and the plurality of transistors of the second inverter are all sequentially arranged in a first direction parallel to a reference plane; and the reference plane is a plane on which a lower surface of the first circuit structure layer is located; and
orthographic projections of the plurality of transistors of the first inverter on the reference plane overlap orthographic projections of the plurality of transistors of the second inverter on the reference plane, and the first inverter is electrically connected to the second inverter through the plurality of interconnection structures.

2. The memory according to claim 1, wherein the transistor comprises a first electrode, a gate, and a second electrode that are sequentially arranged in a second direction, and the second direction is parallel to the reference plane and perpendicular to the first direction; and
in an orthographic projection toward the reference plane, the gate of the transistor of the first inverter overlaps the first electrode of the transistor of the second inverter, and the second electrode of the transistor of the first inverter overlaps the gate of the transistor of the second inverter.

3. The memory according to claim 2, wherein in the orthographic projection toward the reference plane, the first electrode of the transistor of the first inverter is staggered with the second electrode of the transistor of the second inverter.

4. The memory according to claim 2 or 3, wherein the first inverter comprises a first transistor, a second transistor, a third transistor, and a fourth transistor; in the first direction, the third transistor, the first transistor, the fourth transistor, and the second transistor are sequentially arranged; and the first transistor and the fourth transistor share a gate; and
the first circuit structure layer further comprises a first connection line and a second connection line, a second electrode of the third transistor is electrically connected to a second electrode of the first transistor through the first connection line, and a second electrode of the fourth transistor is electrically connected to a second electrode of the second transistor through the second connection line.

5. The memory according to claim 4, wherein the second inverter comprises a fifth transistor, a sixth transistor, a seventh transistor, and an eighth transistor; in the first direction, the fifth transistor, the seventh transistor, the sixth transistor, and the eighth transistor are sequentially arranged; and the sixth transistor and the seventh transistor share a gate; and
the second circuit structure layer further comprises a third connection line and a fourth connection line, a first electrode of the fifth transistor is electrically connected to a first electrode of the seventh transistor through the third connection line, and a first electrode of the sixth transistor is electrically connected to a first electrode of the eighth transistor through the fourth connection line.

6. The memory according to claim 5, wherein the plurality of interconnection structures comprise a first interconnection structure, a second interconnection structure, a third interconnection structure, and a fourth interconnection structure; and
a gate of the third transistor is electrically connected to the first electrode of the seventh transistor through the first interconnection structure; the gate of the seventh transistor is electrically connected to the first connection line through the second interconnection structure; the gate of the first transistor is electrically connected to the fourth connection line through the third interconnection structure; and a gate of the eighth transistor is electrically connected to the second connection line through the fourth interconnection structure.

7. The memory according to claim 5 or 6, wherein the first circuit structure layer further comprises a first gating transistor, and in the first direction, the first gating transistor is located on a side that is of the third transistor and that is away from the first transistor;
the second circuit structure layer further comprises a second gating transistor, and in the first direction, the second gating transistor is located on a side that is of the eighth transistor and that is away from the sixth transistor; and
the first gating transistor and the second gating transistor comprise first electrodes, gates, and second electrodes that are sequentially arranged in the second direction; and the second electrode of the first gating transistor is electrically connected to the first connection line.

8. The memory according to claim 7, wherein the plurality of interconnection structures comprise a fifth interconnection structure, and the first electrode of the second gating transistor is electrically connected to a gate of the second transistor through the fifth interconnection structure.

9. The memory according to claim 7 or 8, further comprising:
a fifth connection line and a sixth connection line, located on a side that is of the second circuit structure layer and that is away from the first circuit structure layer; and
the fifth connection line is electrically connected to a gate of the fifth transistor and the gate of the eighth transistor; the sixth connection line is electrically connected to the third connection line and the first electrode of the second gating transistor; and in the orthographic projection toward the reference plane, the fifth connection line overlaps the gate of the fifth transistor and the gate of the eighth transistor, and the sixth connection line overlaps the first electrode of the seventh transistor and the first electrode of the second gating transistor.

10. The memory according to any one of claims 7 to 9, wherein
the gate of the first gating transistor comprises a first part and a second part, and the second part is away from the third transistor relative to the first part; and in the orthographic projection toward the reference plane, the first part overlaps the first electrode of the fifth transistor, and the second part does not overlap the first electrode of the fifth transistor; and
the memory further comprises a word line, located on the side that is of the second circuit structure layer and that is away from the first circuit structure layer, wherein the word line extends in the first direction; and the word line is electrically connected to the gate of the first gating transistor and the gate of the second gating transistor, and in the orthographic projection toward the reference plane, the word line overlaps the second part and the gate of the second gating transistor.

11. The memory according to any one of claims 7 to 10, further comprising:
a first bit line and a second bit line, located on the side that is of the second circuit structure layer and that is away from the first circuit structure layer, and extending in the second direction, wherein
the first bit line is electrically connected to the first electrode of the first gating transistor, and the second bit line is electrically connected to the second electrode of the second gating transistor; and in the orthographic projection toward the reference plane, the first bit line overlaps the first electrode of the first gating transistor, and the second bit line overlaps the second electrode of the second gating transistor.

12. The memory according to any one of claims 7 to 10, further comprising:
a first bit line, a plurality of first supply voltage lines, and a plurality of first ground lines, located on a side that is of the first circuit structure layer and that is away from the second circuit structure layer, and all extending in the second direction; and
a second bit line, a plurality of second supply voltage lines, and a plurality of second ground lines, located on the side that is of the second circuit structure layer and that is away from the first circuit structure layer, and all extending in the second direction, wherein
the first bit line is electrically connected to the first electrode of the first gating transistor, the plurality of first supply voltage lines are electrically connected to a first electrode of the first transistor and a first electrode of the second transistor, and the plurality of first ground lines are electrically connected to a first electrode of the third transistor and a first electrode of the fourth transistor; and in the orthographic projection toward the reference plane, the first bit line overlaps the first electrode of the first gating transistor, the plurality of first supply voltage lines overlap the first electrode of the first transistor and the first electrode of the second transistor, and the plurality of first ground lines overlap the first electrode of the third transistor and the first electrode of the fourth transistor; and
the second bit line is electrically connected to the second electrode of the second gating transistor, the plurality of second supply voltage lines are electrically connected to a second electrode of the fifth transistor and a second electrode of the sixth transistor, and the plurality of second ground lines are electrically connected to a second electrode of the seventh transistor and a second electrode of the eighth transistor; and in the orthographic projection toward the reference plane, the second bit line overlaps the second electrode of the second gating transistor, the plurality of second supply voltage lines overlap the second electrode of the fifth transistor and the second electrode of the sixth transistor, and the plurality of second ground lines overlap the second electrode of the seventh transistor and the second electrode of the eighth transistor.

13. The memory according to claim 4, wherein the second inverter comprises a fifth transistor, a sixth transistor, a seventh transistor, and an eighth transistor; in the first direction, the seventh transistor, the sixth transistor, the eighth transistor, and the fifth transistor are sequentially arranged; and the fifth transistor and the eighth transistor share a gate, and the sixth transistor and the seventh transistor share a gate; and
the second circuit structure layer further comprises a seventh connection line, and a first electrode of the sixth transistor is electrically connected to a first electrode of the eighth transistor through the seventh connection line.

14. The memory according to claim 13, wherein the plurality of interconnection structures comprise a first interconnection structure, a second interconnection structure, a third interconnection structure, a fourth interconnection structure, and a fifth interconnection structure; and
a gate of the third transistor is electrically connected to a first electrode of the seventh transistor through the first interconnection structure; the gate of the seventh transistor is electrically connected to the first connection line through the second interconnection structure; the gate of the first transistor is electrically connected to the seventh connection line through the third interconnection structure; the second connection line is electrically connected to the gate of the eighth transistor through the fourth interconnection structure; and a gate of the second transistor is electrically connected to a first electrode of the fifth transistor through the fifth interconnection structure.

15. The memory according to claim 13 or 14, wherein the first circuit structure layer further comprises a first gating transistor and a second gating transistor, and in the first direction, the first gating transistor is located on a side that is of the third transistor and that is away from the first transistor, and the second gating transistor is located on a side that is of the second transistor and that is away from the fourth transistor;
the second circuit structure layer further comprises a third gating transistor and a fourth gating transistor, and in the first direction, the third gating transistor is located on a side that is of the seventh transistor and that is away from the sixth transistor, and the fourth gating transistor is located on a side that is of the fifth transistor and that is away from the eighth transistor;
the first gating transistor, the second gating transistor, the third gating transistor, and the fourth gating transistor comprise first electrodes, gates, and second electrodes that are sequentially arranged in the second direction; and the second electrode of the first gating transistor is electrically connected to the first connection line, and the second electrode of the second gating transistor is electrically connected to the second connection line; and
the second circuit structure layer further comprises an eighth connection line, and the first electrode of the fifth transistor is electrically connected to the first electrode of the fourth gating transistor through the eighth connection line.

16. The memory according to claim 15, further comprising:
a ninth connection line and a tenth connection line, located on a side that is of the second circuit structure layer and that is away from the first circuit structure layer; and the ninth connection line is electrically connected to the first electrode of the third gating transistor and the seventh connection line, and the tenth connection line is electrically connected to the first electrode of the seventh transistor and the eighth connection line.

17. The memory according to claim 16, further comprising:
two first connection parts, wherein one end of the ninth connection line is electrically connected to the first electrode of the third gating transistor through one of the first connection parts, and the other end of the ninth connection line is electrically connected to the seventh connection line through the other of the first connection parts; and
two second connection parts, wherein one end of the tenth connection line is electrically connected to the first electrode of the seventh transistor through one of the second connection parts, and the other end of the tenth connection line is electrically connected to the eighth connection line through the other of the second connection parts;
the two first connection parts and the two second connection parts are alternately arranged in the first direction; and
the ninth connection line and the tenth connection line are at a same layer, the ninth connection line avoids the second connection part, and the tenth connection line avoids the first connection part; or the ninth connection line is located on a side that is of the tenth connection line and that is away from the second circuit structure layer, and the tenth connection line is in a broken line shape; and in the orthographic projection toward the reference plane, the tenth connection line avoids the first connection part.

18. The memory according to any one of claims 15 to 17, wherein
the gate of the first gating transistor comprises a first part and a second part, and the second part is away from the third transistor relative to the first part; and in the orthographic projection toward the reference plane, the first part overlaps the first electrode of the third gating transistor, and the second part does not overlap the first electrode of the third gating transistor;
the gate of the second gating transistor comprises a third part and a fourth part, and the fourth part is away from the second transistor relative to the third part; and in the orthographic projection toward the reference plane, the third part overlaps the first electrode of the fourth gating transistor, and the fourth part does not overlap the first electrode of the fourth gating transistor; and
the memory further comprises a word line, the word line is located on the side that is of the second circuit structure layer and that is away from the first circuit structure layer, and extends in the first direction; the word line is electrically connected to the gate of the first gating transistor, the gate of the second gating transistor, the gate of the third gating transistor, and the gate of the fourth gating transistor; and in the orthographic projection toward the reference plane, the word line overlaps the second part, the fourth part, the gate of the third gating transistor, and the gate of the fourth gating transistor.

19. The memory according to any one of claims 15 to 18, further comprising:
a first bit line and a second bit line, located on the side that is of the second circuit structure layer and that is away from the first circuit structure layer, and extending in the second direction, wherein
the first bit line is electrically connected to the first electrode of the first gating transistor and the second electrode of the third gating transistor, and the second bit line is electrically connected to the first electrode of the second gating transistor and the second electrode of the fourth gating transistor; and in the orthographic projection toward the reference plane, the first bit line overlaps the first electrode of the first gating transistor and the second electrode of the third gating transistor, and the second bit line overlaps the first electrode of the second gating transistor and the second electrode of the fourth gating transistor.

20. The memory according to any one of claims 15 to 18, further comprising:
a first bit line, a second bit line, a plurality of first supply voltage lines, and a plurality of first ground lines, located on a side that is of the first circuit structure layer and that is away from the second circuit structure layer, and all extending in the second direction; and
a third bit line, a fourth bit line, a plurality of second supply voltage lines, and a plurality of second ground lines, located on the side that is of the second circuit structure layer and that is away from the first circuit structure layer, and all extending in the second direction, wherein
the first bit line is electrically connected to the first electrode of the first gating transistor, the second bit line is electrically connected to the first electrode of the second gating transistor, the plurality of first supply voltage lines are electrically connected to a first electrode of the first transistor and a first electrode of the second transistor, and the plurality of first ground lines are electrically connected to a first electrode of the third transistor and a first electrode of the fourth transistor; and in the orthographic projection toward the reference plane, the first bit line overlaps the first electrode of the first gating transistor, the second bit line overlaps the first electrode of the second gating transistor, the plurality of first supply voltage lines overlap the first electrode of the first transistor and the first electrode of the second transistor, and the plurality of first ground lines overlap the first electrode of the third transistor and the first electrode of the fourth transistor; and
the third bit line is electrically connected to the second electrode of the third gating transistor, the fourth bit line is electrically connected to the second electrode of the fourth gating transistor, the plurality of second supply voltage lines are electrically connected to a second electrode of the fifth transistor and a second electrode of the sixth transistor, and the plurality of second ground lines are electrically connected to a second electrode of the seventh transistor and a second electrode of the eighth transistor; and in the orthographic projection toward the reference plane, the third bit line overlaps the second electrode of the third gating transistor, the fourth bit line overlaps the second electrode of the fourth gating transistor, the plurality of second supply voltage lines overlap the second electrode of the fifth transistor and the second electrode of the sixth transistor, and the plurality of second ground lines overlap the second electrode of the seventh transistor and the second electrode of the eighth transistor.

21. An electronic device, comprising a circuit board and the memory according to any one of claims 1 to 20, wherein the memory is electrically connected to the circuit board.
